# EUROPEAN PATENT APPLICATION

(11) **EP 4 836 654 A1**
(43) Date of publication of application: **04.11.2026**
(21) Application number: 26167912.0
(22) Date of filing: 26.03.2026
(51) Int. Cl.: H10K 59/131, G09G 3/3233, H10D 86/60, H10K 59/80, H10K 59/126

(54) **DISPLAY APPARATUS AND ELECTRONIC APPARATUS INCLUDING THE SAME**

(30) Priority: 28.04.2025 KR 20250055744; 24.06.2025 KR 20250083859
(71) Applicant: Samsung Display Co., Ltd., Yongin-si, Gyeonggi-do 17113 (KR)
(72) Inventor: Jo, Yongjun, 17113 Yongin-si, Gyeonggi-do (KR); No, Taehyoung, 17113 Yongin-si, Gyeonggi-do (KR)
(74) Representative: Gulde & Partner

(57) **Abstract**

A display apparatus includes a fan-out line portion including a straight portion and a diagonal portion, a first driving voltage supply line overlapping the diagonal portion and extending in a first direction, a second driving voltage supply line extending in a second direction and connected to the first driving voltage supply line, a common voltage supply line spaced apart from the second driving voltage supply line, a cover conductive layer in an area overlapping the diagonal portion, covering at least a portion of an area between the second driving voltage supply line and the common voltage supply line, and electrically connected to the common voltage supply line, and a light blocking layer arranged on the cover conductive layer overlapping a portion of the cover conductive layer, wherein the cover conductive layer includes a contact portion connected to the common voltage supply line in an area overlapping the light blocking layer.

## Description

### BACKGROUND

A display apparatus may visually display data. The display apparatus may include a substrate divided into a display area and a peripheral area outside the display area. The display area may include a scan line and a data line formed to be insulated from each other, and a plurality of pixels arranged to be connected to the scan line and the data line. Also, the display area may include a transistor corresponding to each of the pixels, and a pixel electrode electrically connected to the transistor. Also, the display area may include an opposite electrode provided in common to the pixels. The peripheral area may include various lines configured to transmit electrical signals to the display area.

Recently, the display apparatus has been used for various purposes. Accordingly, research has been actively conducted on a way to reduce or efficiently use the peripheral area of the display apparatus.

### SUMMARY

Some example embodiments relate to a display apparatus and an electronic apparatus including the display apparatus.

Some example embodiments include a display apparatus with excellent display quality. However, these problems are merely examples and the scope of the inventive concepts are not limited thereto.

Some example embodiments will be set forth in part in the description which follows and, in part, will be apparent from the description, or may be learned by practice of some example embodiments of the inventive concepts.

According to some example embodiments, a display apparatus includes a substrate including a display area including a plurality of pixels and a peripheral area outside the display area and including a pad area, a fan-out line portion extending from the pad area to the display area in a plan view and including a straight portion and a diagonal portion, a first driving voltage supply line on the diagonal portion of the fan-out line portion, overlapping the diagonal portion of the fan-out line portion, and extending in a first direction in the plan view, a second driving voltage supply line on the first driving voltage supply line, extending in a second direction intersecting the first direction in the plan view, and electrically connected to the first driving voltage supply line, a common voltage supply line on the first driving voltage supply line and spaced apart from the second driving voltage supply line in the plan view, a cover conductive layer on the second driving voltage supply line and the common voltage supply line in an area overlapping the diagonal portion of the fan-out line portion, covering at least a portion of an area between the second driving voltage supply line and the common voltage supply line in the plan view, and electrically connected to the common voltage supply line, and a light blocking layer on the cover conductive layer in the peripheral area and overlapping a portion of the cover conductive layer, wherein the cover conductive layer includes a contact portion electrically connected to the common voltage supply line in an area overlapping the light blocking layer.

The pad area may be an area in which pads are disposed, wherein a printed circuit board and/or a driver IC chip may be attached to the pads. The straight portion may extend in a straight line in the first or second direction and the diagonal portion may in a diagonal direction from the straight portion. For example, the diagonal portion of the fan-out line portion may extend in a diagonal direction between the first direction and the second direction.

In some example embodiments, the common voltage supply line may include a plurality of first through holes passing through the common voltage supply line, and the cover conductive layer may include a plurality of second through holes passing through the cover conductive layer and respectively overlapping the plurality of first through holes.

In some example embodiments, the display apparatus may further include a via insulating layer between the common voltage supply line and the cover conductive layer, wherein the via insulating layer may include an opening surrounding each of the plurality of second through holes in the plan view, and the contact portion of the cover conductive layer may be in the opening of the via insulating layer.

In some example embodiments, the opening of the via insulating layer may overlap the light blocking layer.

In some example embodiments, the display apparatus may further include a via insulating layer between the common voltage supply line and the cover conductive layer, wherein the via insulating layer may include an opening group including a plurality of openings between adjacent second through holes among the plurality of second through holes in the plan view, and the contact portion of the cover conductive layer may be in the opening group of the via insulating layer.

In some example embodiments, the opening group of the via insulating layer may overlap the light blocking layer.

In some example embodiments, the cover conductive layer may extend in the first direction.

In some example embodiments, the cover conductive layer may overlap the diagonal portion of the fan-out line portion.

In some example embodiments, the cover conductive layer may include a stem portion overlapping the light blocking layer and a branch portion extending from the stem portion in the second direction and covering at least a portion of an area between the second driving voltage supply line and the common voltage supply line.

In some example embodiments, the display apparatus may further include a first initialization voltage supply line on the first driving voltage supply line and between the common voltage supply line and the second driving voltage supply line in the plan view, wherein the branch portion of the cover conductive layer may include a first sub-branch portion covering an area between the common voltage supply line and the first initialization voltage supply line.

In some example embodiments, the display apparatus may further include a second initialization voltage supply line on the first driving voltage supply line and between the first initialization voltage supply line and the second driving voltage supply line in the plan view, wherein the branch portion of the cover conductive layer may include a second sub-branch portion spaced apart from the first sub-branch portion in the first direction and covering an area between the first initialization voltage supply line and the second initialization voltage supply line.

In some example embodiments, the cover conductive layer may be spaced apart from the display area.

In some example embodiments, the display apparatus may further include a driving voltage bus line between the fan-out line portion and the display area in the plan view and extending in the second direction.

In some example embodiments, the cover conductive layer may not overlap the driving voltage bus line.

In some example embodiments, a width in the second direction of an area in which the contact portion of the cover conductive layer and the light blocking layer overlap each other may be 30 µm to 100 µm.

In some example embodiments, each of the plurality of pixels may include a light emitting diode, the light emitting diode may include a pixel electrode on a pixel circuit layer, an emission layer on the pixel electrode, and an opposite electrode on the emission layer, and the cover conductive layer and the pixel electrode may be in a same layer.

In some example embodiments, the opposite electrode may extend from the display area to the peripheral area to overlap at least a portion of the cover conductive layer.

In some example embodiments, the opposite electrode may overlap a portion of the cover conductive layer and may not overlap the light blocking layer.

According to some example embodiments, an electronic apparatus includes a display apparatus configured to display an image, a memory configured to store an application, and a processor configured to execute the application and transmit an image data signal or a control signal to the display apparatus, wherein the display apparatus includes a substrate including a display area and a peripheral area outside the display area and including a pad area, a fan-out line portion extending from the pad area to the display area in a plan view and including a straight portion and a diagonal portion, a first driving voltage supply line on the diagonal portion of the fan-out line portion, overlapping the diagonal portion of the fan-out line portion, and extending in a first direction in the plan view, a second driving voltage supply line on the first driving voltage supply line, extending in a second direction intersecting the first direction in the plan view, and electrically connected to the first driving voltage supply line, a common voltage supply line on the first driving voltage supply line and spaced apart from the second driving voltage supply line in the plan view, a cover conductive layer on the second driving voltage supply line and the common voltage supply line in an area overlapping the diagonal portion of the fan-out line portion, covering at least a portion of an area between the second driving voltage supply line and the common voltage supply line in the plan view, and electrically connected to the common voltage supply line, and a light blocking layer on the cover conductive layer in the peripheral area and overlapping a portion of the cover conductive layer, wherein the cover conductive layer includes a contact portion electrically connected to the common voltage supply line in an area overlapping the light blocking layer.

In some example embodiments, the common voltage supply line may include a plurality of first through holes passing through the common voltage supply line, and the cover conductive layer may include a plurality of second through holes passing through the cover conductive layer and respectively overlapping the plurality of first through holes.

### BRIEF DESCRIPTION OF THE DRAWINGS

The above and other example embodiments, features, and advantages of some example embodiments of the inventive concepts will be more apparent from the following description taken in conjunction with the accompanying drawings, in which:
FIG. 1 is a perspective view schematically illustrating a display apparatus according to some example embodiments;
FIG. 2 is a cross-sectional view schematically illustrating the display apparatus of FIG. 1 along line I-I' according to some example embodiments;
FIG. 3 is a plan view schematically illustrating a display panel according to some example embodiments;
FIG. 4 is an equivalent circuit diagram schematically illustrating a pixel of a display panel according to some example embodiments;
FIG. 5 is a cross-sectional view schematically illustrating a portion of a display area of a display panel according to some example embodiments;
FIG. 6 is an enlarged plan view schematically illustrating a portion of a display panel according to some example embodiments and is an enlarged plan view of region 'A' of FIG. 3;
FIG. 7 is an enlarged plan view schematically illustrating a portion of a display panel according to some example embodiments and is an enlarged plan view of region 'B' of FIG. 6;
FIGS. 8 to 10 are plan views separately illustrating the respective layers of the display panel illustrated in FIG. 7;
FIG. 11 is a cross-sectional view schematically illustrating the display panel of FIG. 7 along line II-II' according to some example embodiments ;
FIG. 12 is an enlarged plan view schematically illustrating a portion of a display panel according to some example embodiments and is an enlarged plan view of region 'C' of FIG. 7;
FIG. 13 is a cross-sectional view schematically illustrating the display panel of FIG. 12 along line III-III' according to some example embodiments;
FIG. 14 is an enlarged plan view schematically illustrating a portion of a display panel according to some example embodiments and is an enlarged plan view of region 'C' of FIG. 7;
FIG. 15 is a cross-sectional view schematically illustrating the display panel of FIG. 14 along line IV-IV' according to some example embodiments;
FIG. 16 is an enlarged plan view schematically illustrating a portion of a display panel according to some example embodiments and is an enlarged plan view of region 'B' of FIG. 6;
FIG. 17 is a plan view schematically illustrating a portion of the display panel illustrated in FIG. 7;
FIG. 18 is a cross-sectional view schematically illustrating the display panel of FIG. 16 along line V-V' according to some example embodiments;
FIG. 19 is a block diagram of an electronic apparatus according to some example embodiments; and
FIG. 20 schematically illustrates electronic apparatuses according to some example embodiments.

### DETAILED DESCRIPTION

Reference will now be made in detail to some example embodiments, examples of which are illustrated in the accompanying drawings, wherein like reference numerals refer to like elements throughout. In this regard, some example embodiments may have different forms and should not be construed as being limited to the descriptions set forth herein. Accordingly, some example embodiments are merely described below, by referring to the figures, to explain some example embodiments of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

The disclosure may include some example embodiments and modifications, and some example embodiments thereof are illustrated in the drawings and will be described herein in detail. The effects and features of the inventive concepts and methods of achieving them will become apparent with reference to the example embodiments described below in detail together with the drawings. However, the inventive concepts are not limited to the example embodiments described below and may be implemented in various forms.

Hereinafter, some example embodiments will be described in detail with reference to the accompanying drawings, and in the following description, like reference numerals will denote like elements and redundant descriptions thereof will be omitted for conciseness.

It will be understood that when an element such as a layer, a region, or a plate is referred to as being "on" another element, it may be "directly on" the element or may be "indirectly on" the other element with one or more intervening elements therebetween. Also, sizes of components in the drawings may be exaggerated for convenience of description. In other words, because the sizes and shapes of elements in the drawings are arbitrarily illustrated for convenience of description, the inventive concepts are not limited thereto.

Also, herein, the X axis, the Y axis, and the Z axis are not limited to three axes of the rectangular coordinate system and may be interpreted in a broader sense. For example, the X axis, the Y axis, and the X axis may be perpendicular to one another or may represent different directions that are not perpendicular to one another.

It will be understood that although terms such as "first" and "second" may be used herein to describe various elements, these elements should not be limited by these terms and these terms are only used to distinguish one element from another element.

It will be understood that terms such as "comprise," "include," and "have" used herein specify the presence of stated features or elements, but do not preclude the presence or addition of one or more other features or elements.

As used herein, "A and/or B" represents the case of A, B, or A and B. Also, "at least one of A and B" represents the case of A, B, or A and B.

It will be understood that when a layer, region, or component is referred to as being "connected to" another layer, region, or component, it may be "directly connected to" the other layer, region, or component or may be "indirectly connected to" the other layer, region, or component with one or more intervening layers, regions, or components therebetween. For example, it will be understood that when a layer, region, or component is referred to as being "electrically connected to" another layer, region, or component, it may be "directly electrically connected to" the other layer, region, or component or may be "indirectly electrically connected to" the other layer, region, or component with one or more intervening layers, regions, or components therebetween.

When an element is referred to as being "connected to" or "electrically connected to" another element, the element may be directly connected to the other element, or one or more other intervening elements may be present. For example, an element described as being "connected to" another element may be "electrically connected to" the other element. In contrast, when an element is referred to as being "directly connected to" another element there are no intervening elements present.

When the words "about" and "substantially" are used in this application in connection with a numerical value, it is intended that the associated numerical value include a tolerance of ±10% around the stated numerical value, unless otherwise explicitly defined. Further, regardless of whether numerical values are modified as "about" or "substantially," it will be understood that these values should be construed as including a of ±10% around the stated numerical value.

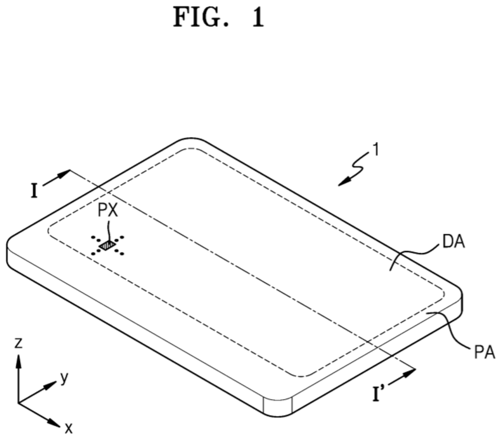

FIG. 1 is a perspective view schematically illustrating a display apparatus according to some example embodiments.

Referring to FIG. 1, a display apparatus 1 may display an image. The display apparatus 1 may include a display area DA and/or a peripheral area PA.

Although a flat display apparatus is illustrated as the display apparatus 1 of FIG. 1, the display apparatus 1 may be implemented in various forms such as a flexible, foldable, and/or rollable display apparatus.

FIG. 1 illustrates the display apparatus 1 including the display area DA having a tetragonal shape; however, in some example embodiments, the display area DA may have a circular shape, an elliptical shape, or a polygonal shape such as a triangular shape or a pentagonal shape. A corner of the edge of the display area DA may be rounded.

In some example embodiments, the display apparatus 1 may include a display area DA that is longer in a first direction (e.g., x direction) than in a second direction (e.g., y direction), as illustrated in FIG. 1. In some example embodiments, the display apparatus 1 may include a display area DA that is shorter in the first direction (e.g., x direction) than in the second direction (e.g., y direction).

A plurality of pixels PX may be arranged in the display area DA. The plurality of pixels PX may emit light, and the display apparatus 1 may display an image in the display area DA. In some example embodiments, any one of the plurality of pixels PX may emit red light, green light, and/or blue light. In some example embodiments, any one of the plurality of pixels PX may emit red light, green light, blue light, and/or white light.

The peripheral area PA may be an area arranged around the display area DA, and the peripheral area PA may surround at least a portion of the display area DA. In some example embodiments, the peripheral area PA may be a non-display area in which pixels PX are not arranged. Various lines configured to transmit electrical signals to be applied to the display area DA, circuits, and/or pads to which a printed circuit board and/or a driver IC chip is attached may be located in the peripheral area PA.

The display apparatus 1 may include, for example, a liquid crystal display, an electrophoretic display, an organic light emitting display, an inorganic EL display (inorganic light emitting display), a field emission display, a surface-conduction electron-emitter display, a quantum dot display, a plasma display, and/or a cathode ray tube display.

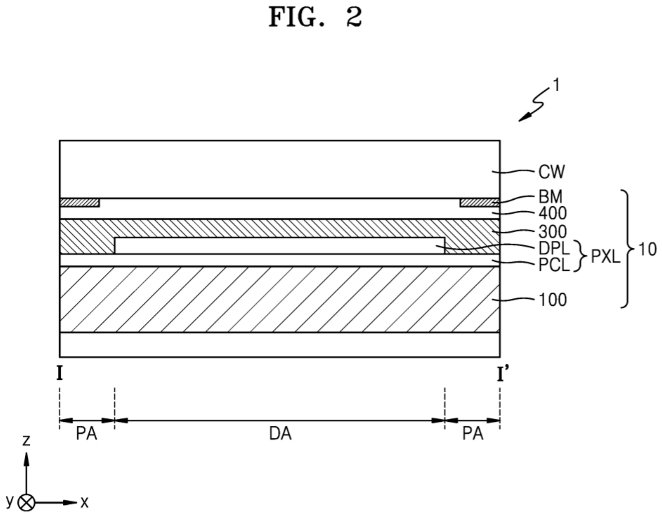

FIG. 2 is a cross-sectional view schematically illustrating the display apparatus 1 of FIG. 1 along line I-I' according to some example embodiments.

Referring to FIG. 2, the display apparatus 1 may include a display panel 10, a light blocking layer BM, and/or a cover window CW.

The display panel 10 may include a display area DA and a peripheral area PA outside the display area DA. The display panel 10 may provide an image through an array of a plurality of pixels arranged in the display area DA. The display panel 10 may be arranged under the cover window CW.

The display panel 10 may include a substrate 100 and an encapsulation layer 300 encapsulating the substrate 100, which are sequentially stacked in a third direction (e.g., z direction).

The substrate 100 may include a glass material and/or may include a polymer resin. For example, the substrate 100 may include a glass material containing SiO₂ as a main component and/or may include various materials having flexible or bendable characteristics, for example, a resin such as reinforced plastic.

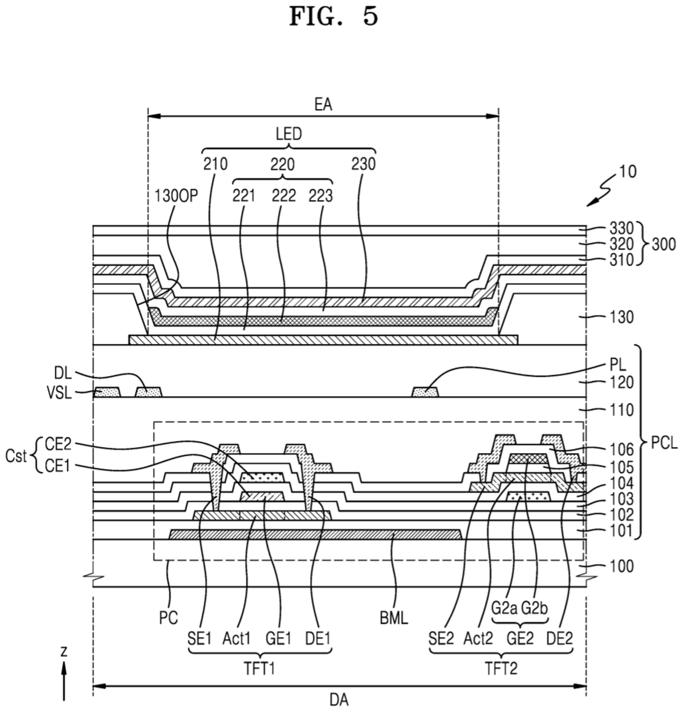

A pixel layer PXL may be arranged on the substrate 100. The pixel layer PXL may include a display device layer DPL including display devices arranged in each, or one or more, pixel and a pixel circuit layer PCL including a pixel circuit and/or insulating layers arranged in each pixel. For example, the pixel circuit layer PCL may include a first thin film transistor TFT1, a second thin film transistor TFT2, a first capacitor Cst, and/or insulating layers as illustrated in FIG. 5. For example, the display element layer DPL may include a light emitting diode LED of FIG. 5 as a display device. Hereinafter, the display apparatus 1 will be described as including an organic light emitting diode as a display device; however, the inventive concepts are not limited thereto. In some example embodiments, the display device may be a light emitting diode including an inorganic material and/or a quantum dot light emitting diode including quantum dots. The display device layer DPL may be arranged on the pixel circuit layer PCL, and a plurality of insulating layers may be arranged between the pixel circuit and the display device. Some lines and insulating layers of the pixel circuit layer PCL may extend to the peripheral area PA.

The encapsulation layer 300 may encapsulate the pixel layer PXL over the pixel layer PXL. The encapsulation layer 300 may be a thin film encapsulation layer. The thin film encapsulation layer may include at least one inorganic encapsulation layer and at least one organic encapsulation layer. When the display panel 10 includes the substrate 100 including a polymer resin and the encapsulation layer 300 of a thin film encapsulation layer including an inorganic encapsulation layer and an organic encapsulation layer, the flexibility of the display apparatus 1 may be improved.

The display panel 10 may include an optical functional layer 400 over the encapsulation layer 300. The optical functional layer 400 may include an anti-reflection layer. The anti-reflection layer may be configured to reduce the reflectance of light (external light) incident from the outside toward the display apparatus 1. The anti-reflection layer may include a phase retarder and/or a polarizer. The phase retarder may be a film type or a liquid crystal coating type and may include a λ/2 phase retarder and/or a λ/4 phase retarder. The polarizer may also be a film type or a liquid crystal coating type. The film type polarizer may include a stretchable synthetic resin film, and the liquid crystal coating type polarizer may include liquid crystals arranged in a certain array. The phase retarder and/or the polarizer may further include a protection film. The protection film of the phase retarder and/or the polarizer may be defined as a base layer of the anti-reflection layer.

In some example embodiments, the anti-reflection layer may include a black matrix and/or color filters. The color filters may be arranged considering the color of light emitted from each, or one or more, of the pixels of the display panel 10. Each, or one or more, of the color filters may include a red, green, and/or blue pigment or dye. Each, or one or more, of the color filters may further include quantum dots in addition to the above pigment or dye. Some of the color filters may not include the above pigment or dye and may include scattering particles such as titanium oxide.

The cover window CW may be arranged on the display panel 10. The cover window CW may transmit light emitted from the display panel 10 to the outside. The cover window CW may include a material having excellent light transmittance, heat resistance, chemical resistance, and/or mechanical strength. In some example embodiments, the cover window CW may include glass and/or a polymer resin. In some example embodiments, the cover window CW may include, for example, a polymer resin such as polyether sulfone, polyacrylate, polyether imide, polyethylene naphthalate, polyethylene terephthalate, polyphenylene sulfide, polyarylate, polyimide, polycarbonate, and/or cellulose acetate propionate. In some example embodiments, the cover window CW may include ultra-thin tempered glass (UTG) strengthened by a method such as chemical strengthening or thermal strengthening.

The light blocking layer BM may be arranged on the display panel 10. For example, the light blocking layer BM may be arranged between the display panel 10 and the cover window CW. For example, the light blocking layer BM may be arranged on the rear surface of the cover window CW. The light blocking layer BM may be arranged in the peripheral area PA. The light blocking layer BM may be implemented in a black color. For example, the light blocking layer BM may include an organic light blocking material and/or an inorganic light blocking material including a black pigment or dye.

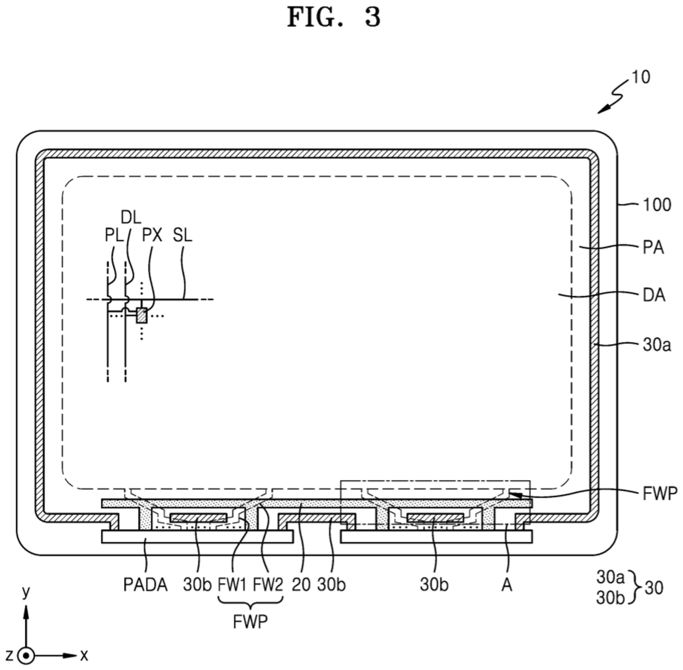

FIG. 3 is a plan view schematically illustrating a display panel according to some example embodiments.

Referring to FIG. 3, a substrate 100 of a display panel 10 may include a display area DA and a peripheral area PA. The peripheral area PA may be located outside the display area DA and may surround the display area DA.

The display area DA of the display panel 10 may include a plurality of pixels PX arranged in a certain pattern in the first direction (e.g., x direction) and the second direction (e.g., y direction). Each, or one or more, of the pixels PX may include a light emitting diode such as an organic light emitting diode and/or a pixel circuit electrically connected to the light emitting diode. Each, or one or more, pixel PX may emit, for example, red, green, blue, and/or white light.

The pixel circuit driving the pixel PX may be connected to a signal line and/or a voltage line configured to control the turning on/off and luminance of the light emitting diode. For example, FIG. 3 illustrates a data line DL and a scan line SL as signal lines and illustrates a driving voltage line PL as a voltage line. The pixel PX may be electrically connected to the data line DL. The scan line SL may extend in the first direction (e.g., x direction). The data line DL may extend in the second direction (e.g., y direction). The pixel PX may be connected to the driving voltage line PL. In the plan view, the scan line SL, the data line DL, and/or the driving voltage line PL may overlap the display area DA.

The peripheral area PA may include a pad area PADA. The pad area PADA may be arranged outside the display area DA. In some example embodiments, the pad area PADA may be provided as a plurality of pad areas PADA. For example, the peripheral area PA may include a plurality of pad areas PADA. In some example embodiments, the plurality of pad areas PADA may be arranged in parallel in the first direction (e.g., x direction). Although FIG. 3 illustrates that there are two pad areas PADA, the inventive concepts are not limited thereto. For example, the peripheral area PA may include one pad area PADA or may include three or more pad areas PADA. Although FIG. 3 illustrates that the pad area PADA is arranged outside from the display area DA in the -y direction, the inventive concepts are not limited thereto. In some example embodiments, the pad area PADA may be arranged outside from the display area DA in the y direction, the -x direction, and/or the x direction.

A plurality of pads may be arranged in the pad area PADA. The pads of the pad area PADA may be exposed, by not being covered by an insulating layer, to be electrically connected to a controller such as a flexible printed circuit board and/or a driver IC chip. For example, the controller may change a plurality of image signals received from the outside into a plurality of image data signals and transmit the changed signals to the display area DA through a data pad among the pads of the pad area PADA. For example, the controller may transmit different voltages respectively to a driving voltage supply line 20 and a common voltage supply line 30 through the pads of the pad area PADA.

The peripheral area PA of the display panel 10 may include outer circuits for driving the pixels PX. For example, the display panel 10 may include a driving voltage supply line 20, a common voltage supply line 30, and/or a fan-out line portion FWP arranged in the peripheral area PA.

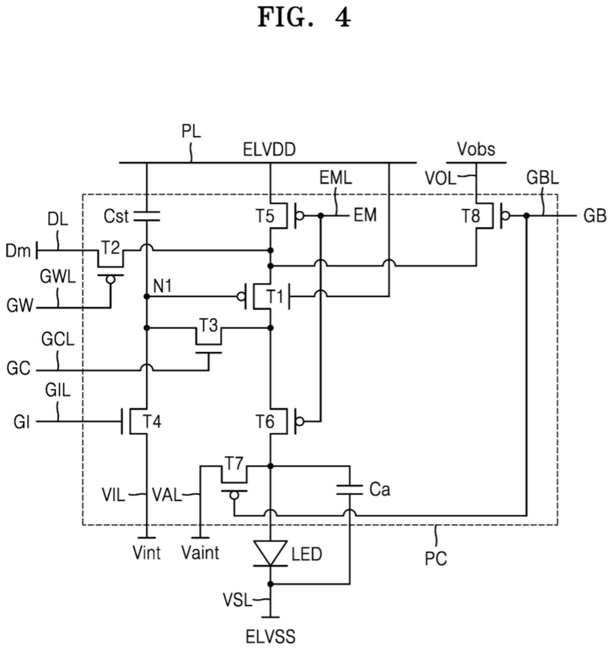

The driving voltage supply line 20 may be arranged between the pad area PADA and the display area DA. The driving voltage supply line 20 may be arranged under the display area DA in the peripheral area PA. For example, the driving voltage supply line 20 may be arranged outside from the display area DA in the -y direction. The driving voltage supply line 20 may be electrically connected to the driving voltage line PL arranged in the display area DA. The driving voltage supply line 20 may be electrically connected to a first power pad among the pads of the pad area PADA. The driving voltage supply line 20 may be configured to provide a driving voltage ELVDD (see FIG. 4) to each, or one or more, pixel PX. For example, the driving voltage ELVDD (see FIG. 4) may be provided to each, or one or more, pixel PX through the driving voltage line PL electrically connected to the driving voltage supply line 20.

The common voltage supply line 30 may include a main common voltage supply line 30a arranged to partially surround the display area DA in the peripheral area PA. A portion of the main common voltage supply line 30a may be arranged between the pad area PADA and the display area DA. In some example embodiments, the main common voltage supply line 30a may extend along the other sides of the display area DA other than one side adjacent to the driving voltage supply line 20.

The common voltage supply line 30 may include a sub common voltage supply line 30b arranged corresponding to one side of the display area DA in the peripheral area PA. For example, the sub common voltage supply line 30b may be arranged under the display area DA in the peripheral area PA. The sub common voltage supply line 30b may be arranged between the pad area PADA and the display area DA. For example, the sub common voltage supply line 30b may be arranged between the driving voltage supply line 20 and the pad area PADA.

The common voltage supply line 30 may be electrically connected to a second power pad among the pads of the pad area PADA. The common voltage supply line 30 may be configured to provide a common voltage ELVSS (see FIG. 4) to each pixel PX. The common voltage supply line 30 may be electrically connected to an opposite electrode 230 (see FIG. 5) of the light emitting diode included in each, or one or more, pixel PX, to provide the common voltage ELVSS (see FIG. 4) to each, or one or more, pixel PX.

The fan-out line portion FWP may be arranged between the display area DA and the pad area PADA. The fan-out line portion FWP may extend from the pad area PADA to the display area DA. For example, the fan-out line portion FWP may include a plurality of fan-out lines, and the plurality of fan-out lines may extend from the pad area PADA to the display area DA.

In some example embodiments, the fan-out line portion FWP may be provided as a plurality of fan-out line portions FWP. For example, the plurality of fan-out line portions FWP may be arranged to respectively correspond to the plurality of pad areas PADA.

In some example embodiments, the fan-out line portion FWP may be electrically connected to the data line DL. The fan-out line portion FWP may be electrically connected to a data pad among the pads of the pad area PADA. The fan-out line portion FWP may be configured to transmit, to the display area DA, a data signal received from the controller through the pad area PADA.

The fan-out line portion FWP may include a straight portion FW1 extending in a straight line in the second direction (e.g., y direction) and a diagonal portion FW2 extending in a diagonal direction from the straight portion FW1. For example, the diagonal portion FW2 of the fan-out line portion FWP may extend in a diagonal direction between the first direction (e.g., x direction) and the second direction (e.g., y direction). In some example embodiments, the fan-out line portion FWP may include a plurality of straight portions FW1 and a plurality of diagonal portions FW2, and the straight portions FW1 and the diagonal portions FW2 may be alternately arranged in the second direction (e.g., y direction).

In some example embodiments, the fan-out line portion FWP may overlap at least a portion of the driving voltage supply line 20. In some example embodiments, the diagonal portion FW2 of the fan-out line portion FWP may overlap at least a portion of the driving voltage supply line 20.

FIG. 4 is an equivalent circuit diagram schematically illustrating a pixel of a display panel according to some example embodiments.

Referring to FIG. 4, a pixel circuit PC may be respectively connected to gate lines, for example, a scan line GWL, a first initialization control line GIL, a second initialization control line GBL, a compensation scan line GCL, and/or an emission control line EML, to receive a scan signal GW, a first initialization control signal GI, a second initialization control signal GB, a compensation scan signal GC, and/or an emission control signal EM. For example, the scan line GWL, the first initialization control line GIL, the second initialization control line GBL, the compensation scan line GCL, and/or the emission control line EML of FIG. 4 may be gate lines connected to the pixel circuit PC located in an i-th row (i is a natural number).

The pixel circuit PC may receive a data signal Dm through a data line DL. For example, the data line DL of FIG. 4 may be a signal line connected to the pixel circuit PC located in a j-th column (j is a natural number).

The pixel circuit PC of the display apparatus according to some example embodiments may be electrically connected to a light emitting diode LED that emits light of a certain color, and the light emitting diode LED may include a first electrode (or pixel electrode or anode), a second electrode (or opposite electrode or cathode), and an intermediate layer therebetween.

The pixel circuit PC may include a plurality of transistors T1, T2, T3, T4, T5, T6, T7, and/or T8 and capacitors Cst and Ca. The plurality of transistors T1, T2, T3, T4, T5, T6, T7, and/or T8 may include a driving transistor T1, a data write transistor T2, a compensation transistor T3, a first initialization transistor T4, an operation control transistor T5, an emission control transistor T6, a second initialization transistor T7, and/or a bias transistor T8. The capacitors Cst and/or Ca may include a first capacitor Cst and a second capacitor Ca.

In some example embodiments, some of the plurality of transistors T1, T2, T3, T4, T5, T6, T7, and/or T8 may be p-channel MOSFETs (PMOSs), and the others may be n-channel MOSFETs (NMOSs). For example, among the plurality of transistors T1, T2, T3, T4, T5, T6, T7, and/or T8, the driving transistor T1, the data write transistor T2, the operation control transistor T5, the emission control transistor T6, the second initialization transistor T7, and/or the bias transistor T8 may be PMOSs, and the compensation transistor T3 and/or the first initialization transistor T4 may be NMOSs. In some example embodiments, among the plurality of transistors T1, T2, T3, T4, T5, T6, T7, and/or T8, the compensation transistor T3 and the first initialization transistor T4 may be PMOSs, and the others may be NMOSs. Alternatively, all, or one or more, of the plurality of transistors T1, T2, T3, T4, T5, T6, T7, and T8 may be NMOSs or may be PMOSs. Hereinafter, a case where the compensation transistor T3 and the first initialization transistor T4 are NMOSs including an oxide semiconductor and the others are PMOSs will be mainly described.

In some example embodiments, at least one of the plurality of transistors T1, T2, T3, T4, T5, T6, T7, and/or T8 may be a transistor including a low-temperature polycrystalline silicon (LTPS) semiconductor layer, and at least one of the plurality of transistors T1, T2, T3, T4, T5, T6, T7, and/or T8 may be a transistor including an oxide semiconductor layer.

The driving transistor T1 directly affecting the brightness of the display apparatus may be configured to include a semiconductor layer including polysilicon having high reliability, and accordingly, a high-resolution display apparatus may be implemented. Because an oxide semiconductor may have a high carrier mobility and a low leakage current, the voltage drop thereof may not be great, even when the driving time thereof is long. For example, low-frequency driving may be possible because a color change of an image due to a voltage drop may not be great, even in low-frequency driving. Because an oxide semiconductor has a small leakage current, at least one of the first initialization transistor T4 and/or the compensation transistor T3 connected to a driving gate electrode of the driving transistor T1 may include an oxide semiconductor to reduce power consumption while reducing, or preventing, a leakage current that may flow to the driving gate electrode. For example, the driving transistor T1, the data write transistor T2, the operation control transistor T5, the emission control transistor T6, the second initialization transistor T7, and/or the bias transistor T8 may be transistors including a low-temperature polysilicon semiconductor layer, and the compensation transistor T3 and/or the first initialization transistor T4 may be transistors including an oxide semiconductor layer.

The driving transistor T1 may be connected between the light emitting diode LED and a driving voltage line PL (or vertical driving voltage line) configured to provide a driving voltage ELVDD. The gate electrode of the driving transistor T1 may be connected to one end of the first capacitor Cst that is a storage capacitor. The gate electrode of the driving transistor T1 may be connected to a first node N1. The source electrode of the driving transistor T1 may be connected to the driving voltage line PL via the operation control transistor T5. The drain electrode of the driving transistor T1 may be electrically connected to the first electrode (or pixel electrode or anode) of the light emitting diode LED via the emission control transistor T6. According to a switching operation of the data write transistor T2, the driving transistor T1 may receive the data signal Dm transmitted by the data line DL and supply a driving current to the light emitting diode LED.

The gate electrode of the data write transistor T2 may be connected to the scan line GWL. The first electrode of the data write transistor T2 may be connected to the data line DL, and the second electrode thereof may be connected to the source electrode of the driving transistor T1. According to the scan signal GW received through the scan line GWL, the data write transistor T2 may be turned on to transmit the data signal Dm received through the data line DL to the source electrode of the driving transistor T1, and simultaneously, the data signal Dm may be transmitted to the gate electrode of the driving transistor T1 by the turned-on compensation transistor T3.

The gate electrode of the compensation transistor T3 may be connected to the compensation scan line GCL. The first electrode of the compensation transistor T3 may be connected to the drain electrode of the driving transistor T1, and the second electrode thereof may be connected to the first node N1. According to the scan signal GW received through the scan line GWL, the compensation transistor T3 may be turned on to connect the gate electrode and the drain electrode of the driving transistor T1 to each other, thereby diode-connecting the driving transistor T1 and compensating for the threshold voltage (Vth) of the driving transistor T1.

The gate electrode of the first initialization transistor T4 may be connected to the first initialization control line GIL. The first electrode of the first initialization transistor T4 may be connected to a first initialization voltage line VIL, and the second electrode thereof may be connected to the first node N1. According to the first initialization control signal GI applied from the first initialization control line GIL, the first initialization transistor T4 may be turned on to transmit a first initialization voltage Vint to the gate electrode of the driving transistor T1, thereby initializing the potential of the gate electrode of the driving transistor T1 (e.g., the potential of the first node N1) to a certain voltage. The first initialization voltage Vint may have a voltage level higher than a common voltage ELVSS or may have a voltage level equal to the common voltage ELVSS.

The gate electrode of the operation control transistor T5 may be connected to the emission control line EML. The first electrode of the operation control transistor T5 may be connected to the driving voltage line PL, and the second electrode thereof may be connected to the source electrode of the driving transistor T1.

The gate electrode of the emission control transistor T6 may be connected to the emission control line EML. The first electrode of the emission control transistor T6 may be connected to the drain electrode of the driving transistor T1, and the second electrode thereof may be electrically connected to the first electrode (or pixel electrode or anode) of the light emitting diode LED. The operation control transistor T5 and the emission control transistor T6 may be simultaneously turned on according to the emission control signal EM applied from the emission control line EML. The driving voltage ELVDD applied through the turned-on operation control transistor T5 may be compensated through the driving transistor T1 and then transmitted to the light emitting diode LED.

The gate electrode of the second initialization transistor T7 may be connected to the second initialization control line GBL. The first electrode of the second initialization transistor T7 may be connected to the first electrode (or pixel electrode or anode) of the light emitting diode LED, and the second electrode thereof may be connected to a second initialization voltage line VAL. By the second initialization control signal GB applied from the second initialization control line GBL, the second initialization transistor T7 may be turned on to initialize the first electrode (or pixel electrode or anode) of the light emitting diode LED. The second initialization control signal GB may be the same as or different from the first initialization control signal GI.

As a comparative example of the inventive concepts, when the light emitting diode LED emits light even when a minimum current of the driving transistor T1 for displaying a black image flows as a driving current, a black image may not be properly displayed. However, according to the inventive concepts, the second initialization transistor T7 may be configured to distribute a portion of the minimum current of the driving transistor T1 as a bypass current to a current path other than the current path toward the light emitting diode LED. Here, the minimum current of the driving transistor T1 may refer to a current under the condition that the gate-source voltage (Vgs) of the driving transistor T1 is lower than the threshold voltage (Vth) of the driving transistor T1 and thus the driving transistor T1 is turned off. As such, the minimum driving current (e.g., a current of 10 picoampere (pA) or less) under the condition of turning off the driving transistor T1 may be transmitted to the light emitting diode LED and thus a black luminance image may be represented. When the minimum driving current for displaying a black image flows, the influence of the bypass transmission of the pass current may be significant, whereas when a large driving current for displaying an image such as a general image or a white image flows, the influence of the bypass current may be almost zero. Thus, when a driving current for displaying a black image flows, an accurate black luminance image may be implemented from the driving current by using the second initialization transistor T7, thereby improving the contrast ratio. Thus, a display apparatus with improved display quality may be provided.

The gate electrode of the bias transistor T8 may be connected to the second initialization control line GBL. The first electrode of the bias transistor T8 may be connected to a bias voltage line VOL through which a bias voltage Vobs is provided, and the second electrode of the bias transistor T8 may be connected to the source electrode of the driving transistor T1.

One end of the first capacitor Cst may be connected to the gate electrode of the driving transistor T1, and the other end thereof may be connected to the driving voltage line PL. The first capacitor Cst may be connected between the driving voltage line PL and the first node N1. The voltage between the driving voltage ELVDD and the first node N1 may be stored in the first capacitor Cst.

The second capacitor Ca may be an auxiliary electrode and may be electrically connected to the emission control transistor T6, the second initialization transistor T7, and the first electrode (or pixel electrode or anode) of the light emitting diode LED. The second capacitor Ca may store and maintain a voltage corresponding to the voltage difference between the first electrode (or pixel electrode or anode) of the light emitting diode LED and a common voltage line VSL while the second initialization transistor T7 is turned on, thereby reducing, or preventing the problem of the black luminance increasing when the emission control transistor T6 is turned off.

The first electrode (or pixel electrode or anode) of the light emitting diode LED may receive a driving current from the driving transistor T1 to emit light, thereby displaying an image. The driving voltage ELVDD may be a certain high-level voltage, and the common voltage ELVSS may be a voltage lower than the driving voltage ELVDD.

The common voltage line VSL may be electrically connected to the common voltage supply line 30 (see FIG. 3) to provide the common voltage ELVSS to the pixel PX.

Hereinafter, an operation process of the pixel circuit PC and the light emitting diode LED will be described.

During an initialization period, a low-level first initialization control signal GI may be supplied to the first initialization transistor T4 through the first initialization control line GIL, and a low-level second initialization control signal GB may be supplied to the second initialization transistor T7 through the second initialization control line GBL. As a result, each of the first initialization transistor T4 and the second initialization transistor T7 may be turned on. The first initialization voltage Vint applied from the first initialization voltage line VIL may be transmitted to the gate electrode of the driving transistor T1 through the first initialization transistor T4, and to the anode through the second initialization transistor T7. Accordingly, the voltage of the anode and the gate electrode of the driving transistor T1 may be initialized.

Thereafter, during a data write period, a low-level scan signal GW may be supplied through the scan line GWL, and the data write transistor T2 and the compensation transistor T3 may be turned on. The data write transistor T2 may be configured to transmit the data signal Dm from the data line DL to the source electrode of the driving transistor T1, and the driving transistor T1 may be diode-connected by the compensation transistor T3. Then, a compensation voltage reduced by the threshold voltage of the driving transistor T1 from the data signal Dm may be applied to the gate electrode of the driving transistor T1.

The driving voltage ELVDD and the compensation voltage may be applied to both ends of the first capacitor Cst, and a charge corresponding to the voltage difference between both ends thereof may be stored in the first capacitor Cst.

Thereafter, during an emission period, the emission control signal EM supplied from the emission control line EML may be changed from a high level to a low level, and the operation control transistor T5 and the emission control transistor T6 may be turned on. Then, a driving current may be generated according to the voltage difference between the driving voltage ELVDD and the voltage of the gate electrode of the driving transistor T1, and the driving current may be supplied to the light emitting diode LED through the emission control transistor T6 to emit light.

The characteristics of light emitting diodes LED emitting different light and/or the characteristics of the respective driving transistors T1 of pixel circuits PC may be different from each other. For example, the color coordinates of the display apparatus 1 may change (e.g., reddish) in the case of high-frequency driving. However, according to the inventive concepts, the voltage of the source electrode of the driving transistor T1 may be controlled by the bias voltage Vobs through the bias transistor T8. By controlling the driving current as such, the subpixel-by-subpixel luminance deviation (current deviation) and the change in the color coordinates may be improved. Thus, a display apparatus with improved display quality may be provided.

FIG. 5 is a cross-sectional view schematically illustrating a portion of a display area of a display panel according to some example embodiments.

Referring to FIG. 5, a display panel 10 may include a pixel circuit PC arranged in a display area DA and a light emitting diode LED electrically connected to the pixel circuit PC. A pixel circuit layer PCL including the pixel circuit PC may be arranged on a substrate 100, and the light emitting diode LED may be arranged on the pixel circuit layer PCL.

The substrate 100 may include glass, metal, and/or polymer resin. In some example embodiments, the substrate 100 may be flexible or bendable. When the substrate 100 is flexible or bendable, the substrate 100 may include, for example, a polymer resin such as polyethersulfone, polyacrylate, polyetherimide, polyethylene naphthalate, polyethylene terephthalate, polyphenylene sulfide, polyarylate, polyimide, polycarbonate, and/or cellulose acetate propionate.

The substrate 100 may have a single-layer or multi-layer structure of the above material and may further include an inorganic layer in the case of having a multi-layer structure. For example, the substrate 100 may include a first organic base layer, a first inorganic barrier layer, a second organic base layer, and/or a second inorganic barrier layer. Each, or one or more, of the first organic base layer and/or the second organic base layer may include a polymer resin. Each, or one or more, of the first inorganic barrier layer and/or the second inorganic barrier layer may be a barrier layer for reducing, or preventing the penetration of external foreign materials and may include a single layer or multiple layers including an inorganic material such as silicon nitride and/or silicon oxide.

A bottom metal layer BML may be arranged on the substrate 100. The bottom metal layer BML may include one or more materials among aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu). In some example embodiments, the bottom metal layer BML may be a single molybdenum layer, may have a bilayer structure in which a molybdenum layer and a titanium layer are stacked, and/or may have a trilayer structure in which a titanium layer, an aluminum layer, and/or a titanium layer are stacked.

The bottom metal layer BML may have a voltage level of a constant voltage. For example, the bottom metal layer BML may be electrically connected to a driving voltage line PL and may have the same voltage level (e.g., the driving voltage ELVDD in FIG. 4) as the driving voltage line PL. The bottom metal layer BML may reduce, or prevent (-) charges from gathering under a first semiconductor layer Act1 of a first thin film transistor TFT1, thus reducing, or preventing or minimizing the problem of a residual image occurring due to (-) charges. When viewed in a direction perpendicular to the upper surface of the substrate 100, the bottom metal layer BML may entirely overlap a channel area of the first semiconductor layer Act1 of the first thin film transistor TFT1.

A buffer layer 101 may be arranged on the bottom metal layer BML. The buffer layer 101 may be an inorganic insulating layer including an inorganic insulating material such as silicon nitride and/or silicon oxide and may have a single-layer or multi-layer structure including the above material.

The first thin film transistor TFT1 may be arranged on the buffer layer 101. The first thin film transistor TFT1 may include the first semiconductor layer Act1, a first gate electrode GE1 over the first semiconductor layer Act1, and/or a first source electrode SE1 and a first drain electrode DE1 each electrically connected to the first semiconductor layer Act1.

The first semiconductor layer Act1 may include a channel area and/or doped areas arranged on both sides of the channel area. The channel area of the first semiconductor layer Act1 may overlap the first gate electrode GE1.

The first semiconductor layer Act1 may include a silicon semiconductor material. For example, the first semiconductor layer Act1 may include amorphous silicon and/or polysilicon. For example, the first semiconductor layer Act1 may include polysilicon crystallized at low temperature.

A first gate insulating layer 102 may be arranged on the first semiconductor layer Act1. The first gate insulating layer 102 may include an inorganic insulating layer including an inorganic insulating material such as silicon oxide, silicon nitride, and/or silicon oxynitride and may have a single-layer or multi-layer structure including the above material.

The first gate electrode GE1 may be arranged on the first gate insulating layer 102. The first gate electrode GE1 and a lower electrode CE1 may be integrally provided as one body. For example, the first gate electrode GE1 may function as the lower electrode CE1 of a first capacitor Cst.

The first gate electrode GE1 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) and may include a single layer or multiple layers including the above material.

A second gate insulating layer 103 may be arranged on the first gate electrode GE1. The second gate insulating layer 103 may include an inorganic insulating layer including an inorganic insulating material such as silicon oxide, silicon nitride, and/or silicon oxynitride and may have a single-layer or multi-layer structure including the above material.

An upper electrode CE2 of the first capacitor Cst may be arranged on the second gate insulating layer 103. The upper electrode CE2 may overlap the first gate electrode GE1 and/or the lower electrode CE1. The first capacitor Cst may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) and may include a single layer or multiple layers including the above material. In some example embodiments, the upper electrode CE2 may include the same material as the lower electrode CE1 and/or the bottom metal layer BML.

A first interlayer insulating layer 104 may be arranged on the upper electrode CE2. The first interlayer insulating layer 104 may include an inorganic insulating layer including an inorganic insulating material such as silicon oxide, silicon nitride, and/or silicon oxynitride and may have a single-layer or multi-layer structure including the above material.

A second thin film transistor TFT2 may be arranged on the first interlayer insulating layer 104. The second thin film transistor TFT2 may include a second semiconductor layer Act2, a second gate electrode GE2 over the second semiconductor layer Act2, and/or a second source electrode SE2 and a second drain electrode DE2 each electrically connected to the second semiconductor layer Act2.

The second semiconductor layer Act2 and the first semiconductor layer Act1 may be arranged on different layers. For example, the first semiconductor layer Act1 may be arranged on the buffer layer 101, and the second semiconductor layer Act2 may be arranged on the first interlayer insulating layer 104. For example, the vertical distance from the substrate 100 to the second semiconductor layer Act2 may be greater than the vertical distance from the substrate 100 to the first semiconductor layer Act1.

The second semiconductor layer Act2 may include a channel area and doped areas arranged on both sides of the channel area. The channel area of the second semiconductor layer Act2 may overlap the second gate electrode GE2.

The second semiconductor layer Act2 may include an oxide semiconductor material. For example, the second semiconductor layer Act2 may include an oxide of at least one of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). For example, the second semiconductor layer Act2 may include InSnZnO (ITZO) or InGaZnO (IGZO). Because the oxide semiconductor has a wide band gap (about 3.1 eV), a high carrier mobility, and a low leakage current, a voltage drop may not be great, even when the driving time is long, and thus, a luminance change due to the voltage drop may not be great, even in the case of low-frequency driving.

The second gate electrode GE2 may be arranged under and/or over the second semiconductor layer Act2. FIG. 5 illustrates some example in which the second gate electrode GE2 includes a lower gate electrode G2a arranged under the second semiconductor layer Act2 and an upper gate electrode G2b arranged on the second semiconductor layer Act2. In some example embodiments, any one of the lower gate electrode G2a and/or the upper gate electrode G2b may be omitted.

The lower gate electrode G2a may include the same material as the upper electrode CE2 and may be located on the same layer (e.g., the second gate insulating layer 103) as the upper electrode CE2. The upper gate electrode G2b may be arranged on the second semiconductor layer Act2. A third gate insulating layer 105 may be arranged between the upper gate electrode G2b and the second semiconductor layer Act2. The upper gate electrode G2b may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) and may include a single layer or multiple layers including the above material.

Although FIG. 5 illustrates that the third gate insulating layer 105 is arranged only between the upper gate electrode G2b and the second semiconductor layer Act2, the inventive concepts are not limited thereto. In some example embodiments, the third gate insulating layer 105 may be formed to entirely cover the substrate 100 like other insulating layers, for example, the first gate insulating layer 102. The third gate insulating layer 105 may include an inorganic insulating layer including an inorganic insulating material such as silicon oxide, silicon nitride, and/or silicon oxynitride and may have a single-layer or multi-layer structure including the above material.

The first thin film transistor TFT1 may be an example of some of the transistors of FIG. 4, and the second thin film transistor TFT2 may be an example of the other transistor of FIG. 4. For example, the first thin film transistor TFT1 may be one of the driving transistor T1, the data write transistor T2, the operation control transistor T5, the emission control transistor T6, the second initialization transistor T7, and/or the bias transistor T8 of FIG. 4, and the second thin film transistor TFT2 may be one of the compensation transistor T3 and/or the first initialization transistor T4 of FIG. 4.

A second interlayer insulating layer 106 may be arranged on the upper gate electrode G2b. The second interlayer insulating layer 106 may include an inorganic insulating layer including an inorganic insulating material such as silicon oxide, silicon nitride, and/or silicon oxynitride and may have a single-layer or multi-layer structure including the above material.

The first source electrode SE1, the first drain electrode DE1, the second source electrode SE2, and/or the second drain electrode DE2 may be arranged on the second interlayer insulating layer 106. Each, or one or more, of the first source electrode SE1, the first drain electrode DE1, the second source electrode SE2, and/or the second drain electrode DE2 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) and may include a single layer or multiple layers including the above material. In some example embodiments, each, or one or more, of the first source electrode SE1, the first drain electrode DE1, the second source electrode SE2, and/or the second drain electrode DE2 may have a three-layer structure of aluminum layer/titanium layer/aluminum layer.

A first via insulating layer 110 may be arranged on the first source electrode SE1, the first drain electrode DE1, the second source electrode SE2, and/or the second drain electrode DE2. The first via insulating layer 110 may cover the first source electrode SE1, the first drain electrode DE1, the second source electrode SE2, and/or the second drain electrode DE2 and may be arranged on the second interlayer insulating layer 106. The first via insulating layer 110 may be referred to as a first planarization layer that provides a flat upper surface.

The first via insulating layer 110 may include an organic insulating material. For example, the first via insulating layer 110 may include a photoresist, benzocyclobutene (BCB), polyimide, hexamethyldisiloxane (HMDSO), polymethylmethacrylate (PMMA), polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcoholbased polymer, and/or any mixture thereof.

The driving voltage line PL, a common voltage line VSL, and/or a data line DL may be arranged on the first via insulating layer 110 in the display area DA. The driving voltage line PL, the common voltage line VSL, and/or the data line DL may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) and may include a single layer or multiple layers including the above material. In some example embodiments , the driving voltage line PL, the common voltage line VSL, and/or the data line DL may have a three-layer structure of aluminum layer/titanium layer/aluminum layer.

A second via insulating layer 120 may be arranged on the driving voltage line PL, the common voltage line VSL, and/or the data line DL. The second via insulating layer 120 may cover the driving voltage line PL, the common voltage line VSL, and/or the data line DL and may be arranged on the first via insulating layer 110. The second via insulating layer 120 may be referred to as a second planarization layer that provides a flat upper surface.

The second via insulating layer 120 may include an organic insulating material. For example, the second via insulating layer 120 may include a photoresist, benzocyclobutene (BCB), polyimide, hexamethyldisiloxane (HMDSO), polymethylmethacrylate (PMMA), polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcoholbased polymer, and/or any mixture thereof.

The light emitting diode LED may be arranged on the second via insulating layer 120. The light emitting diode LED may include a pixel electrode 210, an intermediate layer 220, and/or an opposite electrode 230 over the second via insulating layer 120.

The pixel electrode 210 may include a (semi)transparent electrode or a reflective electrode. For example, the pixel electrode 210 may include a reflective layer including Ag, Mg, Al, Pt, Pd, Au, Ni, Nd, Ir, Cr, and/or any compound thereof and a transparent or semitransparent electrode layer located over the reflective layer. The transparent or semitransparent electrode layer may include at least one of indium tin oxide (ITO), indium zinc oxide (IZO), zinc oxide (ZnO), indium oxide (In₂O₃), indium gallium oxide (IGO), and/or aluminum zinc oxide (AZO). For example, the pixel electrode 210 may have a three-layer structure of ITO/Ag/ITO.

The edge of the pixel electrode 210 may be covered by a bank layer 130, and the inner portion of the pixel electrode 210 may overlap the intermediate layer 220 through a pixel opening 130OP of the bank layer 130. For example, the bank layer 130 may cover the edge of the pixel electrode 210 and may define the pixel opening 130OP that exposes a portion of the pixel electrode 210. The pixel opening 130OP of the bank layer 130 may define an emission area EA of the light emitting diode LED.

While the pixel electrode 210 may be formed for each light emitting diode LED, the opposite electrode 230 may be formed corresponding to a plurality of light emitting diodes LED. For example, the plurality of light emitting diodes LED may share the opposite electrode 230, and a stack structure of the pixel electrode 210, the intermediate layer 220, and the opposite electrode 230 may correspond to the light emitting diode LED.

The intermediate layer 220 may be arranged on the pixel electrode 210. The intermediate layer 220 may include an emission layer 222, a first functional layer 221 arranged under the emission layer 222, and/or a second functional layer 223 arranged on the emission layer 222. The emission layer 222 may have a patterned shape corresponding to the pixel electrode 210. The emission layer 222 may include a highmolecular weight or low-molecular weight organic material for emitting light of a certain color. The first functional layer 221 may be a hole transport layer. In some example embodiments, the first functional layer 221 may include a hole injection layer and/or a hole transport layer. The second functional layer 223 may include an electron transport layer and/or an electron injection layer. The first functional layer 221 and the second functional layer 223 may be integrally formed to correspond to a plurality of light emitting diodes LED. In some example embodiments , the first functional layer 221 and/or the second functional layer 223 may be omitted.

The opposite electrode 230 may be arranged on the intermediate layer 220. The opposite electrode 230 may be a transparent electrode, a semitransparent electrode, or a reflective electrode. The opposite electrode 230 may include, for example, lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), indium tin oxide (ITO), indium zinc oxide (IZO), and/or any combination thereof. The opposite electrode 230 may be integrally formed to correspond to a plurality of light emitting diodes LED.

An encapsulation layer 300 may be arranged on the light emitting diode LED. The encapsulation layer 300 may include at least one inorganic encapsulation layer and at least one organic encapsulation layer. As some example embodiments , FIG. 5 illustrates that the encapsulation layer 300 includes a first inorganic encapsulation layer 310, an organic encapsulation layer 320, and/or a second inorganic encapsulation layer 330.

The first inorganic encapsulation layer 310 and/or the second inorganic encapsulation layer 330 may include an inorganic insulating material such as silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), and/or zinc oxide (ZnOₓ). The first inorganic encapsulation layer 310 and/or the second inorganic encapsulation layer 330 may have a single-layer or multi-layer structure including the above inorganic insulating material.

The organic encapsulation layer 320 may relieve the internal stress of the first inorganic encapsulation layer 310 and/or the second inorganic encapsulation layer 330. The organic encapsulation layer 320 may include a polymer-based material. The polymer-based material may include polyethyleneterephthalate, polyethylenenaphthalate, polycarbonate, polyimide, polyethylenesulfonate, polyoxymethylene, polyarylate, hexamethyldisiloxane, acrylic resin (e.g., polymethylmethacrylate or polyacrylic acid), and/or any combination thereof.

The organic encapsulation layer 320 may be formed by applying a material having flowability and including monomers and then reacting the monomers to be combined into a polymer, by using heat and/or light such as ultraviolet rays. In some example embodiments, the organic encapsulation layer 320 may be formed by applying a polymer material.

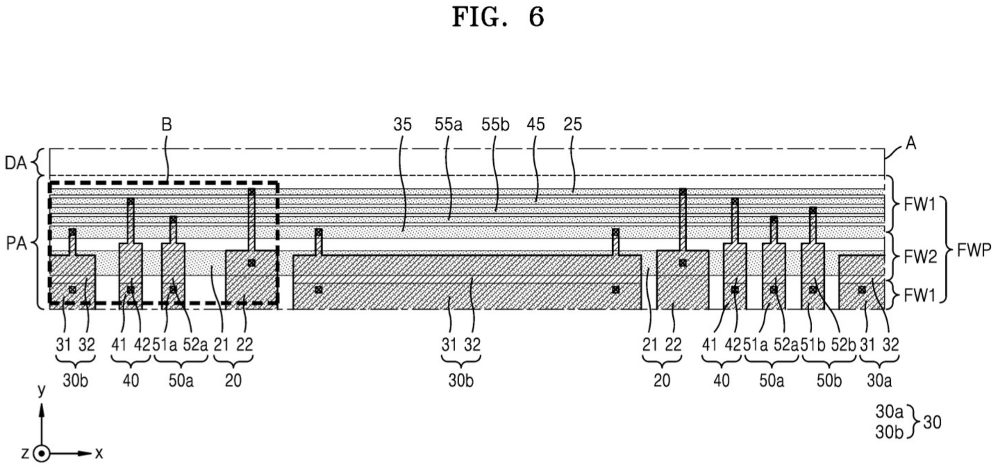

FIG. 6 is an enlarged plan view schematically illustrating a portion of a display panel according to some example embodiments and is an enlarged plan view of region 'A' of FIG. 3.

For convenience of illustration, FIG. 6 schematically illustrates the straight portion FW1 of the fan-out line portion FWP and the diagonal portion FW2 of the fan-out line portion FWP respectively corresponding to the arrangement areas thereof. For example, as illustrated in FIG. 6, the diagonal portion FW2 of the fan-out line portion FWP may be arranged between the straight portions FW1 of the fan-out line portion FWP.

Referring to FIG. 6, the display panel 10 may include a driving voltage bus line 25, a common voltage bus line 35, a first initialization voltage bus line 45, a second-1 initialization voltage bus line 55a, and/or a second-2 initialization voltage bus line 55b arranged in the peripheral area PA.

Each, or one or more, of the driving voltage bus line 25, the common voltage bus line 35, the first initialization voltage bus line 45, the second-1 initialization voltage bus line 55a, and/or the second-2 initialization voltage bus line 55b may be arranged between the display area DA and a first driving voltage supply line 21 described below. Each, or one or more, of the driving voltage bus line 25, the common voltage bus line 35, the first initialization voltage bus line 45, the second-1 initialization voltage bus line 55a, and/or the second-2 initialization voltage bus line 55b may extend in the first direction (e.g., x direction).

Each, or one or more, of the driving voltage bus line 25, the common voltage bus line 35, the first initialization voltage bus line 45, the second-1 initialization voltage bus line 55a, and/or the second-2 initialization voltage bus line 55b may be electrically connected to each, or one or more, pixel PX arranged in the display area DA. For example, the driving voltage bus line 25, the common voltage bus line 35, and/or the first initialization voltage bus line 45 may respectively transmit a driving voltage ELVDD (see FIG. 4), a common voltage ELVSS (see FIG. 4), and/or a first initialization voltage Vint (see FIG. 4) to each, or one or more, pixel PX. For example, the second-1 initialization voltage bus line 55a may be configured to transmit a second initialization voltage Vaint (see FIG. 4) to the pixel PX emitting first color (e.g., green) light and the pixel PX emitting second color (e.g., blue) light. For example, the second-2 initialization voltage bus line 55b may provide a second initialization voltage Vaint (see FIG. 4) to the pixel PX emitting third color (e.g., red) light.

FIG. 6 illustrates that the driving voltage bus line 25 is arranged between the display area DA and the first initialization voltage bus line 45, the first initialization voltage bus line 45 is arranged between the driving voltage bus line 25 and the second-2 initialization voltage bus line 55b, the second-2 initialization voltage bus line 55b is arranged between the first initialization voltage bus line 45 and the second-1 initialization voltage bus line 55a, and the common voltage bus line 35 is arranged between the second-1 initialization voltage bus line 55a and the first driving voltage supply line 21; however, the inventive concepts are not limited thereto. The arrangement order of the driving voltage bus line 25, the common voltage bus line 35, the first initialization voltage bus line 45, the second-1 initialization voltage bus line 55a, and/or the second-2 initialization voltage bus line 55b may be variously modified according to some example embodiments.

The driving voltage supply line 20 may include a first driving voltage supply line 21 and a second driving voltage supply line 22 that are electrically connected to each other.

At least a portion of the first driving voltage supply line 21 may extend in the first direction (e.g., x direction). For example, the first driving voltage supply line 21 may be referred to as a horizontal driving voltage supply line. At least a portion of the first driving voltage supply line 21 may overlap the diagonal portion FW2 of the fan-out line portion FWP. For example, a portion of the first driving voltage supply line 21 that extends in the first direction (e.g., x direction) may overlap the diagonal portion FW2 of the fan-out line portion FWP.

The second driving voltage supply line 22 may be arranged on the first driving voltage supply line 21. At least a portion of the second driving voltage supply line 22 may overlap the first driving voltage supply line 21, and the second driving voltage supply line 22 may be connected (or electrically connected) to the first driving voltage supply line 21 by a contact hole. Because the second driving voltage supply line 22 is arranged on the first driving voltage supply line 21, the first driving voltage supply line 21 and the second driving voltage supply line 22 may be respectively referred to as a lower driving voltage supply line and an upper driving voltage supply line.

The second driving voltage supply line 22 may extend in the second direction (e.g., y direction). For example, the second driving voltage supply line 22 may be referred to as a vertical driving voltage supply line. The second driving voltage supply line 22 may be connected (or electrically connected) to the driving voltage bus line 25 by a contact hole. The second driving voltage supply line 22 may be electrically connected to the pad area PADA described above with reference to FIG. 3. In some example embodiments , the second driving voltage supply line 22 may include a plurality of patterns arranged in the second direction (e.g., y direction). For example, the plurality of patterns of the second driving voltage supply line 22 may be electrically connected to each other by a conductive layer arranged in a different layer than the second driving voltage supply line 22.

The common voltage supply line 30 may include a main common voltage supply line 30a and/or a sub common voltage supply line 30b. In some example embodiments , the main common voltage supply line 30a may be arranged to surround at least a portion of the display area DA and may be connected to an opposite electrode 230 (see FIG. 5) extending from both sides of the display area DA to the peripheral area PA. In some example embodiments , the sub common voltage supply line 30b may be electrically connected to the common voltage bus line 35.

Each, or one or more, of the main common voltage supply line 30a and/or the sub common voltage supply line 30b may include a first common voltage supply line 31 and/or a second common voltage supply line 32.

The second common voltage supply line 32 may be arranged on the first common voltage supply line 31. At least a portion of the second common voltage supply line 32 may overlap the first common voltage supply line 31, and the second common voltage supply line 32 may be connected (or electrically connected) to the first common voltage supply line 31 by a contact hole. Because the second common voltage supply line 32 is arranged over the first common voltage supply line 31, the first common voltage supply line 31 and the second common voltage supply line 32 may be respectively referred to as a lower common voltage supply line and an upper common voltage supply line.

The second common voltage supply line 32 may extend in the second direction (e.g., y direction). In some example embodiments , the second common voltage supply line 32 may be connected (or electrically connected) to the common voltage bus line 35 by a contact hole. For example, the second common voltage supply line 32 of the sub common voltage supply line 30b may be connected (or electrically connected) to the common voltage bus line 35 by a contact hole. The second common voltage supply line 32 may be electrically connected to the pad area PADA described above with reference to FIG. 3. In some example embodiments , the second common voltage supply line 32 may include a plurality of patterns arranged in the second direction (e.g., y direction). For example, the plurality of patterns of the second common voltage supply line 32 may be electrically connected to each other by a conductive layer arranged in a different layer than the second common voltage supply line 32.

The display panel 10 may further include a first initialization voltage supply line 40, a second-1 initialization voltage supply line 50a, and/or a second-2 initialization voltage supply line 50b arranged in the peripheral area PA. The first initialization voltage supply line 40 may be configured to provide a first initialization voltage Vint (see FIG. 4) to each, or one or more, pixel PX. The second-1 initialization voltage supply line 50a and/or the second-2 initialization voltage supply line 50b may be configured to provide a second initialization voltage Vaint (see FIG. 4) to each, or one or more, pixel PX. For example, the second-1 initialization voltage supply line 50a may be configured to provide a second initialization voltage Vaint (see FIG. 4) to the pixel PX emitting first color (e.g., green) light and/or the pixel PX emitting second color (e.g., blue) light, and the second-2 initialization voltage supply line 50b may be configured to provide a second initialization voltage Vaint (see FIG. 4) to the pixel PX emitting third color (e.g., red) light.

The first initialization voltage supply line 40 may include a first lower initialization voltage supply line 41 and/or a first upper initialization voltage supply line 42. The first upper initialization voltage supply line 42 may be arranged on the first lower initialization voltage supply line 41. At least a portion of the first upper initialization voltage supply line 42 may overlap the first lower initialization voltage supply line 41, and the first upper initialization voltage supply line 42 may be connected (or electrically connected) to the first lower initialization voltage supply line 41 by a contact hole.

The first upper initialization voltage supply line 42 may extend in the second direction (e.g., y direction). In some example embodiments , the first upper initialization voltage supply line 42 may be connected (or electrically connected) to a first initialization voltage bus line 45a by a contact hole. The first upper initialization voltage supply line 42 may be electrically connected to the pad area PADA described above with reference to FIG. 3. In some example embodiments, the first upper initialization voltage supply line 42 may include a plurality of patterns arranged in the second direction (e.g., y direction). For example, the plurality of patterns of the first upper initialization voltage supply line 42 may be electrically connected to each other by a conductive layer arranged in a different layer than the first upper initialization voltage supply line 42.

The second-1 initialization voltage supply line 50a may include a second-1 lower initialization voltage supply line 51a and/or a second-1 upper initialization voltage supply line 52a. The second-1 upper initialization voltage supply line 52a may be arranged on the second-1 lower initialization voltage supply line 51a. At least a portion of the second-1 upper initialization voltage supply line 52a may overlap the second-1 lower initialization voltage supply line 51a, and the second-1 upper initialization voltage supply line 52a may be connected (or electrically connected) to the second-1 lower initialization voltage supply line 51a by a contact hole.

The second-1 upper initialization voltage supply line 52a may extend in the second direction (e.g., y direction). In some example embodiments , the second-1 upper initialization voltage supply line 52a may be connected (or electrically connected) to the second-1 initialization voltage bus line 55a by a contact hole. The second-1 upper initialization voltage supply line 52a may be electrically connected to the pad area PADA described above with reference to FIG. 3. In some example embodiments , the second-1 upper initialization voltage supply line 52a may include a plurality of patterns arranged in the second direction (e.g., y direction). For example, the plurality of patterns of the second-1 upper initialization voltage supply line 52a may be electrically connected to each other by a conductive layer arranged in a different layer than the second-1 upper initialization voltage supply line 52a.

The second-2 initialization voltage supply line 50b may include a second-2 lower initialization voltage supply line 51b and/or a second-2 upper initialization voltage supply line 52b. The second-2 upper initialization voltage supply line 52b may be arranged on the second-2 lower initialization voltage supply line 51b. At least a portion of the second-2 upper initialization voltage supply line 52b may overlap the second-2 lower initialization voltage supply line 51b, and the second-2 upper initialization voltage supply line 52b may be connected (or electrically connected) to the second-2 lower initialization voltage supply line 51b by a contact hole.

The second-2 upper initialization voltage supply line 52b may extend in the second direction (e.g., y direction). In some example embodiments , the second-2 upper initialization voltage supply line 52b may be connected (or electrically connected) to the second-2 initialization voltage bus line 55b by a contact hole. The second-2 upper initialization voltage supply line 52b may be electrically connected to the pad area PADA described above with reference to FIG. 3. In some example embodiments , the second-2 upper initialization voltage supply line 52b may include a plurality of patterns arranged in the second direction (e.g., y direction). For example, the plurality of patterns of the second-2 upper initialization voltage supply line 52b may be electrically connected to each other by a conductive layer arranged on a different layer than the second-2 upper initialization voltage supply line 52b.

In some example embodiments , the first lower initialization voltage supply line 41 and/or the second-1 lower initialization voltage supply line 51a may be arranged between the first driving voltage supply line 21 and/or the first common voltage supply line 31 of the sub common voltage supply line 30b. For example, as illustrated in FIG. 6, the first lower initialization voltage supply line 41 may be arranged between the first common voltage supply line 31 and the second-1 lower initialization voltage supply line 51a, and the second-1 lower initialization voltage supply line 51a may be arranged between the first lower initialization voltage supply line 41 and the first driving voltage supply line 21.

In some example embodiments , the first lower initialization voltage supply line 41, the second-1 lower initialization voltage supply line 51a, and the second-2 lower initialization voltage supply line 51b may be arranged between the first driving voltage supply line 21 and/or the first common voltage supply line 31 of the main common voltage supply line 30a. For example, the first lower initialization voltage supply line 41 may be arranged between the first driving voltage supply line 21 and/or the second-1 lower initialization voltage supply line 51a, the second-1 lower initialization voltage supply line 51a may be arranged between the first lower initialization voltage supply line 41 and/or the second-2 lower initialization voltage supply line 51b, and the second-2 lower initialization voltage supply line 51b may be arranged between the second-1 lower initialization voltage supply line 51a and/or the first common voltage supply line 31.

In some example embodiments , the first common voltage supply line 31 of the sub common voltage supply line 30b may be arranged between the first driving voltage supply lines 21.

However, the arrangement of each, or one or more, of the voltage supply lines is not limited to that illustrated in FIG. 6 and may be variously modified. In some example embodiments, the second-1 lower initialization voltage supply line 51a and/or the second-2 lower initialization voltage supply line 51b may be arranged between the first driving voltage supply line 21 and the first common voltage supply line 31 of the sub common voltage supply line 30b.

In some example embodiments , the first upper initialization voltage supply line 42 and/or the second-1 upper initialization voltage supply line 52a may be arranged between the second driving voltage supply line 22 and the second common voltage supply line 32 of the sub common voltage supply line 30b. For example, as illustrated in FIG. 6, the first upper initialization voltage supply line 42 may be arranged between the second common voltage supply line 32 and the second-1 upper initialization voltage supply line 52a, and the second-1 upper initialization voltage supply line 52a may be arranged between the first upper initialization voltage supply line 42 and the second driving voltage supply line 22.

In some example embodiments , the first upper initialization voltage supply line 42, the second-1 upper initialization voltage supply line 52a, and/or the second-2 upper initialization voltage supply line 52b may be arranged between the second driving voltage supply line 22 and the second common voltage supply line 32 of the main common voltage supply line 30a. For example, the first upper initialization voltage supply line 42 may be arranged between the second driving voltage supply line 22 and the second-1 upper initialization voltage supply line 52a, the second-1 upper initialization voltage supply line 52a may be arranged between the first upper initialization voltage supply line 42 and the second-2 upper initialization voltage supply line 52b, and/or the second-2 upper initialization voltage supply line 52b may be arranged between the second-1 upper initialization voltage supply line 52a and the second common voltage supply line 32.

In some example embodiments , the second common voltage supply line 32 of the sub common voltage supply line 30b may be arranged between the second driving voltage supply lines 22.

However, the arrangement of each, or one or more, of the voltage supply lines is not limited to that illustrated in FIG. 6 and may be variously modified. In some example embodiments, the second-1 upper initialization voltage supply line 52a and/or the second-2 upper initialization voltage supply line 52b may be arranged between the second driving voltage supply line 22 and the second common voltage supply line 32 of the sub common voltage supply line 30b.

In some example embodiments , the driving voltage bus line 25, the common voltage bus line 35, the first initialization voltage bus line 45, the second-1 initialization voltage bus line 55a, the second-2 initialization voltage bus line 55b, the first driving voltage supply line 21, the first common voltage supply line 31, the first lower initialization voltage supply line 41, the second-1 lower initialization voltage supply line 51a, and/or the second-2 lower initialization voltage supply line 51b may be arranged on the same layer (e.g., the second interlayer insulating layer 106 (see FIG. 5)).

In some example embodiments , the second driving voltage supply line 22, the second common voltage supply line 32, the first upper initialization voltage supply line 42, the second-1 upper initialization voltage supply line 52a, and/or the second-2 upper initialization voltage supply line 52b may be arranged on the same layer (e.g., the first via insulating layer 110 (see FIG. 5)).

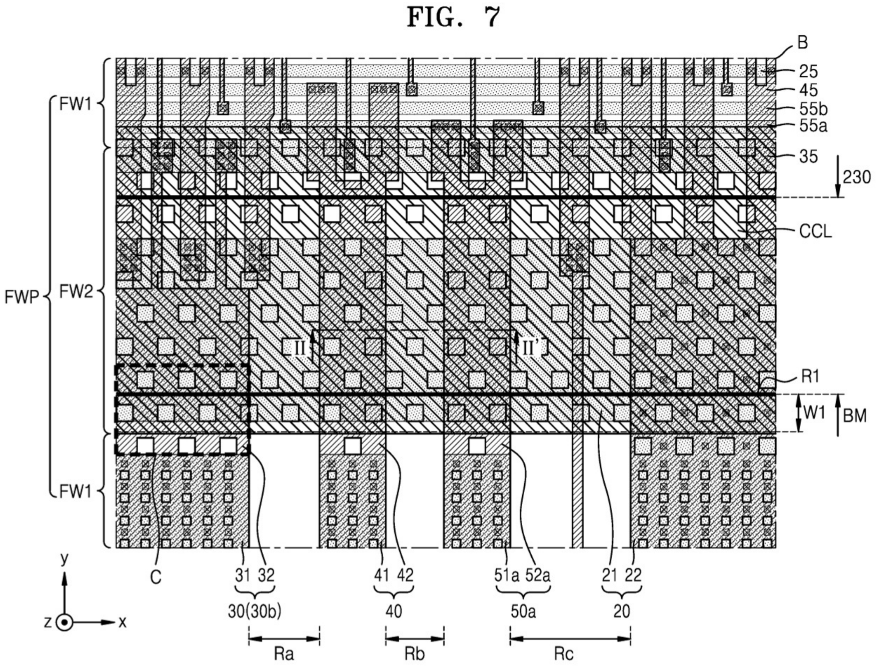

FIG. 7 is an enlarged plan view schematically illustrating a portion of a display panel according to some example embodiments and is an enlarged plan view of region 'B' of FIG. 6.

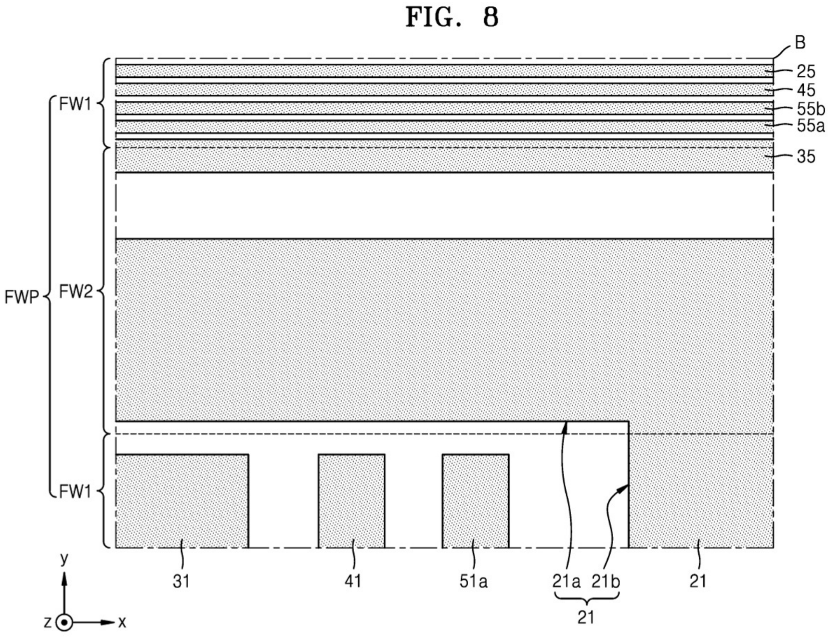

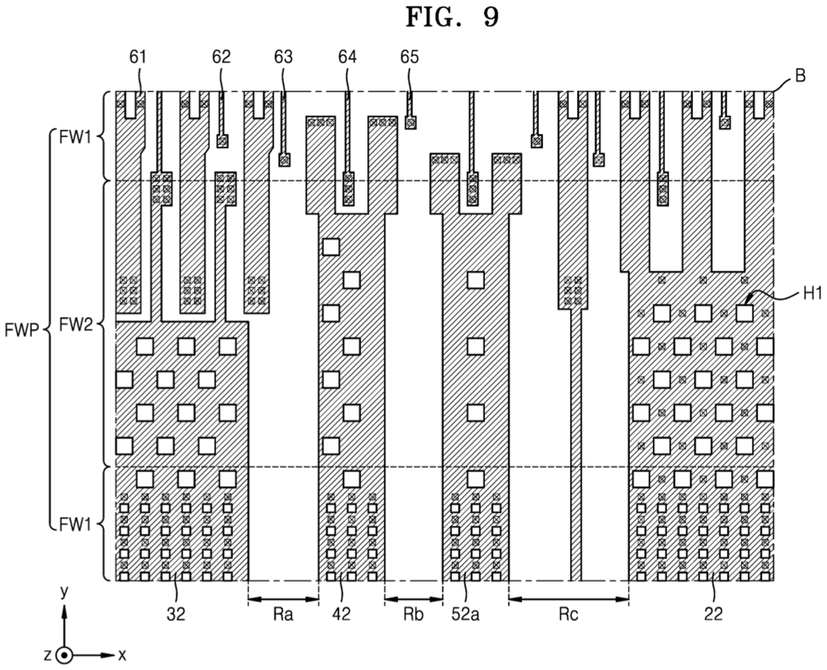

FIGS. 8 to 10 are plan views separately illustrating the respective layers of the display panel illustrated in FIG. 7. In other words, FIG. 7 illustrates that the respective layers described with reference to FIGS. 8 to 10 are sequentially stacked.

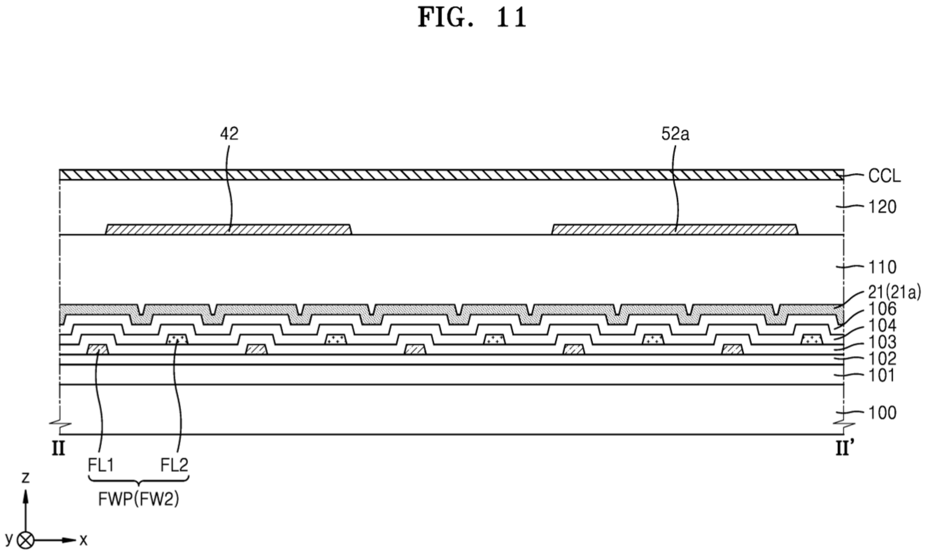

FIG. 11 is a cross-sectional view schematically illustrating the display panel of FIG. 7 along line II-II' according to some example embodiments .

Referring to FIGS. 7 and 11, the fan-out line portion FWP may include a first fan-out layer FL1 and/or a second fan-out layer FL2. For example, each, or one or more, of the straight portion FW1 and/or the diagonal portion FW2 of the fan-out line portion FWP may include a first fan-out layer FL1 and/or a second fan-out layer FL2. In the plan view, the first fan-out layer FL1 and the second fan-out layer FL2 may be alternately arranged with each other. For example, in the plan view, the second fan-out layer FL2 may be arranged between adjacent first fan-out layers FL1. For example, in the plan view, the first fan-out layer FL1 may be arranged between adjacent second fan-out layers FL2.

In some example embodiments , the second fan-out layer FL2 may be arranged over the first fan-out layer FL1. The first fan-out layer FL1 and the second fan-out layer FL2 may not overlap each other. In some example embodiments , the first fan-out layer FL1 may be arranged on the same layer (e.g., the first gate insulating layer 102) as the first gate electrode GE1 of FIG. 5. In some example embodiments , the second fan-out layer FL2 may be arranged on the same layer (e.g., the second gate insulating layer 103) as the upper electrode CE2 of the first capacitor Cst of FIG. 5.

Each, or one or more, of the first fan-out layer FL1 and/or the second fan-out layer FL2 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) and may include a single layer or multiple layers including the above material. The first fan-out layer FL1 and the second fan-out layer FL2 may include the same conductive material or may include different conductive materials.

A first interlayer insulating layer 104 may be arranged on the fan-out line portion FWP, and a second interlayer insulating layer 106 may be arranged on the first interlayer insulating layer 104.

Referring to FIGS. 7, 8, and 11, the driving voltage bus line 25, the common voltage bus line 35, the first initialization voltage bus line 45, the second-1 initialization voltage bus line 55a, the second-2 initialization voltage bus line 55b, the first driving voltage supply line 21, the first common voltage supply line 31, the first lower initialization voltage supply line 41, and/or the second-1 lower initialization voltage supply line 51a may be arranged on the fan-out line portion FWP. The driving voltage bus line 25, the common voltage bus line 35, the first initialization voltage bus line 45, the second-1 initialization voltage bus line 55a, the second-2 initialization voltage bus line 55b, the first driving voltage supply line 21, the first common voltage supply line 31, the first lower initialization voltage supply line 41, and/or the second-1 lower initialization voltage supply line 51a may be arranged on the second interlayer insulating layer 106.

Each, or one or more, of the driving voltage bus line 25, the common voltage bus line 35, the first initialization voltage bus line 45, the second-1 initialization voltage bus line 55a, and/or the second-2 initialization voltage bus line 55b may be arranged between the display area DA (see FIG. 6) and a first portion 21a of the first driving voltage supply line 21 described below.

In some example embodiments , at least some of the driving voltage bus line 25, the common voltage bus line 35, the first initialization voltage bus line 45, the second-1 initialization voltage bus line 55a, and/or the second-2 initialization voltage bus line 55b may overlap the straight portion FW1 of the fan-out line portion FWP. For example, as illustrated in FIG. 8, the driving voltage bus line 25, the first initialization voltage bus line 45, the second-1 initialization voltage bus line 55a, and/or the second-2 initialization voltage bus line 55b may overlap the straight portion FW1, and a portion of the common voltage bus line 35 may overlap the diagonal portion FW2. However, the inventive concepts are not limited to the illustrated, and for example, each, or one or more, of the driving voltage bus line 25, the common voltage bus line 35, the first initialization voltage bus line 45, the second-1 initialization voltage bus line 55a, and/or the second-2 initialization voltage bus line 55b may overlap the straight portion FW1.

In some example embodiments , at least some of the driving voltage bus line 25, the common voltage bus line 35, the first initialization voltage bus line 45, the second-1 initialization voltage bus line 55a, and/or the second-2 initialization voltage bus line 55b may not overlap a cover conductive layer CCL described below. For example, as illustrated in FIG. 7, the driving voltage bus line 25, the first initialization voltage bus line 45, and/or the second-2 initialization voltage bus line 55b may not overlap the cover conductive layer CCL. However, the inventive concepts are not limited to the illustrated, and for example, each, or one or more, of the driving voltage bus line 25, the common voltage bus line 35, the first initialization voltage bus line 45, the second-1 initialization voltage bus line 55a, and/or the second-2 initialization voltage bus line 55b may not overlap the cover conductive layer CCL.

The first driving voltage supply line 21 may include a first portion 21a extending in the first direction (e.g., x direction) and/or a second portion 21b extending from the first portion 21a in a direction (e.g., -y direction) toward the pad area PADA (see FIG. 3). The first portion 21a of the first driving voltage supply line 21 may be arranged on the diagonal portion FW2 of the fan-out line portion FWP and may overlap the diagonal portion FW2 of the fan-out line portion FWP.

The first common voltage supply line 31 and the first portion 21a of the first driving voltage supply line 21 may be spaced apart from each other in the second direction (e.g., y direction). For example, the first common voltage supply line 31 may be spaced apart from the first portion 21a of the first driving voltage supply line 21 in the -y direction. The first common voltage supply line 31 and the second portion 21b of the first driving voltage supply line 21 may be spaced apart from each other in the first direction (e.g., x direction). For example, the first common voltage supply line 31 may be spaced apart from the second portion 21b of the first driving voltage supply line 21 in the -x direction.

In some example embodiments, the first lower initialization voltage supply line 41 and/or the second-1 lower initialization voltage supply line 51a may be arranged between the second portion 21b of the first driving voltage supply line 21 and the first common voltage supply line 31. For example, as illustrated in FIG. 6, the first lower initialization voltage supply line 41 may be arranged between the first common voltage supply line 31 and the second-1 lower initialization voltage supply line 51a, and the second-1 lower initialization voltage supply line 51a may be arranged between the first lower initialization voltage supply line 41 and the second portion 21b of the first driving voltage supply line 21.

Each, or one or more, of the driving voltage bus line 25, the common voltage bus line 35, the first initialization voltage bus line 45, the second-1 initialization voltage bus line 55a, the second-2 initialization voltage bus line 55b, the first driving voltage supply line 21, the first common voltage supply line 31, the first lower initialization voltage supply line 41, and/or the second-1 lower initialization voltage supply line 51a may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) and may include a single layer or multiple layers including the above material.

A first via insulating layer 110 may be arranged on the driving voltage bus line 25, the common voltage bus line 35, the first initialization voltage bus line 45, the second-1 initialization voltage bus line 55a, the second-2 initialization voltage bus line 55b, the first driving voltage supply line 21, the first common voltage supply line 31, the first lower initialization voltage supply line 41, and/or the second-1 lower initialization voltage supply line 51a.

Referring to FIGS. 7, 8, 9, and 11, the second driving voltage supply line 22, the second common voltage supply line 32, the first upper initialization voltage supply line 42, and/or the second-1 upper initialization voltage supply line 52a may be arranged on the first driving voltage supply line 21. At least a portion of each, or one or more, of the second driving voltage supply line 22, the second common voltage supply line 32, the first upper initialization voltage supply line 42, and/or the second-1 upper initialization voltage supply line 52a may overlap the first portion 21a of the first driving voltage supply line 21. The second driving voltage supply line 22, the second common voltage supply line 32, the first upper initialization voltage supply line 42, and/or the second-1 upper initialization voltage supply line 52a may be arranged on the first via insulating layer 110.

The second driving voltage supply line 22, the second common voltage supply line 32, the first upper initialization voltage supply line 42, and/or the second-1 upper initialization voltage supply line 52a may be spaced apart from each other in the first direction (e.g., x direction).

In some example embodiments , a portion of the first driving voltage supply line 21 may be exposed in a first region Ra between the second common voltage supply line 32 and the first upper initialization voltage supply line 42. In some example embodiments , a portion of the first driving voltage supply line 21 may be exposed in a second region Rb between the first upper initialization voltage supply line 42 and the second-1 upper initialization voltage supply line 52a. In some example embodiments , a portion of the first driving voltage supply line 21 may be exposed in a third region Rc between the second-1 upper initialization voltage supply line 52a and the second driving voltage supply line 22. For example, the first portion 21a of the first driving voltage supply line 21 may be exposed in the first region Ra, the second region Rb, and the third region Rc. In this paragraph, being exposed may mean that it does not overlap the second driving voltage supply line 22 and the conductive lines (e.g., the second common voltage supply line 32, the first upper initialization voltage supply line 42, and/or the second-1 upper initialization voltage supply line 52a) arranged on the same layer as the second driving voltage supply line 22.

In an area where the first portion 21a of the first driving voltage supply line 21 overlaps the diagonal portion FW2 of the fan-out line portion FWP, the first portion 21a of the first driving voltage supply line 21 may include a portion that overlaps and a portion that is exposed by not overlapping the second driving voltage supply line 22 and the conductive lines (e.g., the second common voltage supply line 32, the first upper initialization voltage supply line 42, and/or the second-1 upper initialization voltage supply line 52a) arranged on the same layer as the second driving voltage supply line 22.

Each, or one or more, of the second driving voltage supply line 22, the second common voltage supply line 32, the first upper initialization voltage supply line 42, and/or the second-1 upper initialization voltage supply line 52a may include a plurality of first through holes H1. For example, the first through holes H1 of the second driving voltage supply line 22 may pass through the second driving voltage supply line 22, the first through holes H1 of the second common voltage supply line 32 may pass through the second common voltage supply line 32, the first through holes H1 of the first upper initialization voltage supply line 42 may pass through the first upper initialization voltage supply line 42, and/or the first through holes H1 of the second-1 upper initialization voltage supply line 52a may pass through the second-1 upper initialization voltage supply line 52a.

The first through holes H1 of the second driving voltage supply line 22, the second common voltage supply line 32, the first upper initialization voltage supply line 42, and/or the second-1 upper initialization voltage supply line 52a may function as an outgasing path for discharging gas in the organic insulating layer (e.g., the first via insulating layer 110 and/or the second via insulating layer 120).

Each, or one or more, of the second driving voltage supply line 22, the second common voltage supply line 32, the first upper initialization voltage supply line 42, and/or the second-1 upper initialization voltage supply line 52a may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) and may include a single layer or multiple layers including the above material.

The display panel 10 (see FIG. 3) may include a driving voltage transmission line 61, a second-2 initialization voltage transmission line 62, a second-1 initialization voltage transmission line 63, a common voltage transmission line 64, and/or a first initialization voltage transmission line 65 arranged in the peripheral area PA (see FIG. 6).

The driving voltage transmission line 61, the second-2 initialization voltage transmission line 62, the second-1 initialization voltage transmission line 63, the common voltage transmission line 64, and/or the first initialization voltage transmission line 65 may be arranged on the same layer (e.g., the first via insulating layer 110) and may include the same material as the second driving voltage supply line 22.

Each, or one or more, of the driving voltage transmission line 61, the second-2 initialization voltage transmission line 62, the second-1 initialization voltage transmission line 63, the common voltage transmission line 64, and/or the first initialization voltage transmission line 65 may extend in the second direction (e.g., y direction).

The driving voltage transmission line 61 may electrically connect the first driving voltage supply line 21 and the driving voltage bus line 25 to each other. For example, the driving voltage transmission line 61 may be connected to the first driving voltage supply line 21 at one end by a contact hole, and to the driving voltage bus line 25 at the other end by a contact hole.

The second-2 initialization voltage transmission line 62 may be electrically connected to the second-2 initialization voltage bus line 55b and may extend to the display area DA (see FIG. 6) to be electrically connected to the pixel circuit PC (see FIG. 5). The second-2 initialization voltage transmission line 62 may be connected to the second-2 initialization voltage bus line 55b by a contact hole.

The second-1 initialization voltage transmission line 63 may be electrically connected to the second-1 initialization voltage bus line 55a and may extend to the display area DA (see FIG. 6) to be electrically connected to the pixel circuit PC (see FIG. 5). The second-1 initialization voltage transmission line 63 may be connected to the second-1 initialization voltage bus line 55a by a contact hole.

The common voltage transmission line 64 may be electrically connected to the common voltage bus line 35 and may extend to the display area DA (see FIG. 6) to be electrically connected to the pixel circuit PC (see FIG. 5). The common voltage transmission line 64 may be connected to the common voltage bus line 35 by a contact hole.

The first initialization voltage transmission line 65 may be electrically connected to the first initialization voltage bus line 45 and may extend to the display area DA (see FIG. 6) to be electrically connected to the pixel circuit PC (see FIG. 5). The first initialization voltage transmission line 65 may be connected to the first initialization voltage bus line 45 by a contact hole.

A second via insulating layer 120 may be arranged on the second driving voltage supply line 22, the second common voltage supply line 32, the first upper initialization voltage supply line 42, the second-1 upper initialization voltage supply line 52a, the driving voltage transmission line 61, the second-2 initialization voltage transmission line 62, the second-1 initialization voltage transmission line 63, the common voltage transmission line 64, and/or the first initialization voltage transmission line 65.

Referring to FIGS. 7 to 11, the cover conductive layer CCL may be arranged on the second driving voltage supply line 22, the second common voltage supply line 32, the first upper initialization voltage supply line 42, and/or the second-1 upper initialization voltage supply line 52a.

In some example embodiments, the cover conductive layer CCL may be arranged on the same layer (e.g., the second via insulating layer 120) as the pixel electrode 210 (see FIG. 5) of the light emitting diode LED (see FIG. 5). However, the inventive concepts are not limited thereto, and the cover conductive layer CCL may be arranged on the same layer as the uppermost conductive layer among the conductive layers arranged under the light emitting diode LED (see FIG. 5).

The cover conductive layer CCL may include the same conductive material as the pixel electrode 210 (see FIG. 5). For example, the cover conductive layer CCL may include a reflective layer including Ag, Mg, Al, Pt, Pd, Au, Ni, Nd, Ir, Cr, and/or any compound thereof and a transparent or semitransparent electrode layer located over the reflective layer. The transparent or semitransparent electrode layer may include at least one of indium tin oxide (ITO), indium zinc oxide (IZO), zinc oxide (ZnO), indium oxide (In₂O₃), indium gallium oxide (IGO), and/or aluminum zinc oxide (AZO). For example, the cover conductive layer CCL may have a three-layer structure of ITO/Ag/ITO.

The cover conductive layer CCL may be located in the peripheral area PA and may be spaced apart from the display area DA (see FIG. 6). For example, the cover conductive layer CCL may be spaced apart from the display area DA by a distance of about 70 µm or more. The space between the cover conductive layer CCL and the display area DA may function as an outgasing path due to the discharge of gas in the organic insulating layer (e.g., the first via insulating layer 110 and/or the second via insulating layer 120), thus reducing the shrinkage risk of the display panel 10 (see FIG. 3). For example, when the cover conductive layer CCL is spaced apart from the display area DA by a distance of about 70 µm or more, the shrinkage risk of the display panel 10 (see FIG. 3) may be more effectively reduced.

The cover conductive layer CCL may overlap the diagonal portion FW2 of the fan-out line portion FWP. In some example embodiments , the cover conductive layer CCL may overlap the diagonal portion FW2 but may only partially overlap or may not overlap each, or one or more, of the straight portions FW1 arranged over and under the diagonal portion FW2. In some example embodiments , the cover conductive layer CCL may only partially overlap each, or one or more, of the second common voltage supply line 32, the first upper initialization voltage supply line 42, the second-1 upper initialization voltage supply line 52a, and/or the second driving voltage supply line 22. In some example embodiments, the area of the cover conductive layer CCL may be formed not to be excessively large, thus reducing the shrinkage risk of the display panel 10 (see FIG. 3) due to outgasing. For example, the cover conductive layer CCL of some example embodiments may be smaller than a conventional cover conductive layer.

In some example embodiments , the cover conductive layer CCL may extend in the first direction (e.g., x direction) in an area overlapping the diagonal portion FW2 of the fan-out line portion FWP. For example, in an area overlapping the diagonal portion FW2 of the fan-out line portion FWP, the cover conductive layer CCL may cover or overlap each, or one or more, of the second common voltage supply line 32, the first upper initialization voltage supply line 42, the second-1 upper initialization voltage supply line 52a, and/or the second driving voltage supply line 22.

In an area overlapping the diagonal portion FW2 of the fan-out line portion FWP, the cover conductive layer CCL may cover or overlap at least a portion of the area between the second common voltage supply line 32 and the second driving voltage supply line 22. The cover conductive layer CCL may cover or overlap each, or one or more, of the first region Ra between the second common voltage supply line 32 and the first upper initialization voltage supply line 42, the second region Rb between the first upper initialization voltage supply line 42 and the second-1 upper initialization voltage supply line 52a, and/or the third region Rc between the second-1 upper initialization voltage supply line 52a and the second driving voltage supply line 22. The cover conductive layer CCL may cover or overlap the area between the second common voltage supply line 32 and the second driving voltage supply line 22 that are adjacent to each other, as illustrated in FIG. 6. The cover conductive layer CCL may cover or overlap the area between the second driving voltage supply line 22 and the first upper initialization voltage supply line 42 that are adjacent to each other, the area between the second-1 upper initialization voltage supply line 52a and the second-2 upper initialization voltage supply line 52b that are adjacent to each other, and/or the area between the second-2 upper initialization voltage supply line 52b and the second common voltage supply line 32 that are adjacent to each other, as illustrated in FIG. 6.

The cover conductive layer CCL may include a plurality of second through holes H2 passing through the cover conductive layer CCL. The second through holes H2 of the cover conductive layer CCL may overlap the first through holes H1. For example, the second through holes H2 of the cover conductive layer CCL may overlap the first through holes H1 of the second driving voltage supply line 22, the first through holes H1 of the second common voltage supply line 32, the first through holes H1 of the first upper initialization voltage supply line 42, and/or the first through holes H1 of the second-1 upper initialization voltage supply line 52a.

The second through holes H2 of the cover conductive layer CCL may function as an outgasing path for discharging gas in the organic insulating layer (e.g., the first via insulating layer 110 and/or the second via insulating layer 120). In some example embodiments , because the first through holes H1 overlap the second through holes H2, the length of the outgasing path may be formed shorter, thereby effectively discharging gas in the organic insulating layer (e.g., the first via insulating layer 110 and/or the second via insulating layer 120).

Because the first driving voltage supply line 21 is arranged under the first via insulating layer 110 and the second via insulating layer 120 corresponding to a planarization layer, the first driving voltage supply line 21 may have a curved upper surface due to the fan-out line portion FWP in an area overlapping the diagonal portion FW2 of the fan-out line portion FWP. An area of the first driving voltage supply line 21 that is not overlapped by the conductive layers over the first via insulating layer 110 or the second via insulating layer 120 may have a different external light reflectance than an area of the first driving voltage supply line 21 that is overlapped by the conductive layers over the first via insulating layer 110 or the second via insulating layer 120.

In an area overlapping the diagonal portion FW2 of the fan-out line portion FWP, in the case of a comparative example in which the cover conductive layer is not arranged on the first driving voltage supply line 21 and thus the first driving voltage supply line 21 does not overlap the conductive layers over the first via insulating layer 110, the external light reflectances between the area overlapping the conductive layers over the first via insulating layer 110 and the area not overlapping the conductive layers on the first via insulating layer 110 may be different from each other and thus a phenomenon in which spots or reflective color bands are visible may occur. For example, in an area where the first portion 21a of the first driving voltage supply line 21 and the diagonal portion FW2 of the fan-out line portion FWP overlap each other, the external light reflectances between the area in which the second driving voltage supply line 22, the second common voltage supply line 32, the first upper initialization voltage supply line 42, and the second-1 upper initialization voltage supply line 52a are arranged (or overlap) and the area in which they are not arranged (or dot not overlap) may be different from each other and thus a phenomenon in which spots or reflective color bands are visible may occur.

In some example embodiments , the cover conductive layer CCL may extend in the first direction (e.g., x direction) in an area where the first portion 21a of the first driving voltage supply line 21 and the diagonal portion FW2 of the fan-out line portion FWP overlap each other, and thus, the first portion 21a of the first driving voltage supply line 21 may not include an area that overlaps the cover conductive layer CCL over the first via insulating layer 110 and does not overlap the conductive layers over the first via insulating layer 110. Thus, because external light is uniformly reflected by the cover conductive layer CCL, the phenomenon of spots or reflective color bands may be effectively reduced, thus improving the display quality of the display panel 10 (see FIG. 3).

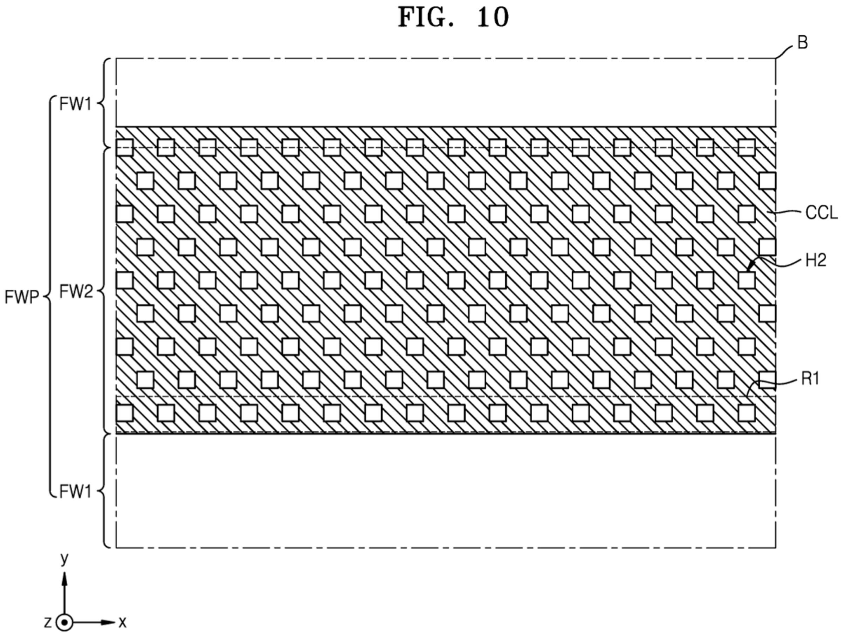

Referring to FIGS. 7 and 10, a portion of the cover conductive layer CCL may overlap a light blocking layer BM. The light blocking layer BM may be arranged on the cover conductive layer CCL in the peripheral area PA (see FIG. 6). The light blocking layer BM may cover a portion of the cover conductive layer CCL and may extend toward the pad area PADA (see FIG. 3).

The light blocking layer BM may be arranged apart from the display area DA, may overlap a portion of the peripheral area PA, and may not overlap the other portions thereof. In some example embodiments , by arranging the cover conductive layer CCL in a non-overlapping area of the light blocking layer BM in the peripheral area PA (e.g., an area in which the first portion 21a of the first driving voltage supply line 21 and the diagonal portion FW2 of the fan-out line portion FWP overlap each other), it may be possible to reduce or prevent the appearance of spots or reflective color bands due to external light reflection.

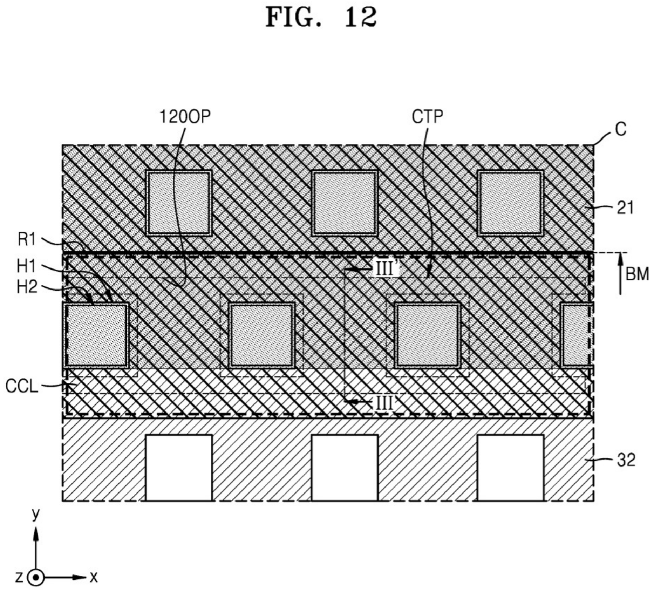

In a region R1 where the cover conductive layer CCL and the light blocking layer BM overlap each other, the cover conductive layer CCL may be connected (or electrically connected) to the second common voltage supply line 32. Because the cover conductive layer CCL includes a contact portion connected to the second common voltage supply line 32 in the region R1 overlapping the light blocking layer BM, it may be possible to reduce or prevent the occurrence of a reflective color band phenomenon due to the contact portion of the cover conductive layer CCL. This will be described below in detail with reference to FIGS. 12 to 15.

In order to prevent or reduce the shrinkage risk of the display panel 10 (see FIG. 3) due to gas discharged from the organic insulating layer, the cover conductive layer CCL according to some example embodiments may overlap the light blocking layer BM only in some areas for arranging the contact portion and may not overlap the light blocking layer BM in the other areas.

A width W1 in the second direction (e.g., y direction) of the region R1 in which the cover conductive layer CCL and the light blocking layer BM overlap each other may be about 30 µm to about 100 µm. When the area of the cover conductive layer CCL increases and thus the width W1 of the overlapping region R1 of the cover conductive layer CCL and the light blocking layer BM exceeds 100 µm, the shrinkage risk of the display panel 10 (see FIG. 3) due to the discharge of gas in the organic insulating layer (e.g., the first via insulating layer 110 and/or the second via insulating layer 120) may increase significantly. When the width W1 of the overlapping region R1 of the cover conductive layer CCL and the light blocking layer BM is less than 30 µm, because the contact portion of the cover conductive layer CCL and the second common voltage supply line 32 do not overlap the light blocking layer BM, areas having different external light reflectances may occur and thus the display quality of the display panel 10 (see FIG. 3) may be degraded. According to some example embodiments , because the width W1 in the second direction (e.g., y direction) of the region R1 in which the cover conductive layer CCL and the light blocking layer BM overlap each other is about 30 µm to about 100 µm, the shrinkage risk of the display panel 10 (see FIG. 3) may be significantly reduced and the display quality may be improved.

The opposite electrode 230 may extend from the display area DA (see FIG. 6) to the peripheral area PA (see FIG. 6) to overlap at least a portion of the cover conductive layer CCL. The opposite electrode 230 may be arranged on the cover conductive layer CCL. The opposite electrode 230 may be electrically connected to the cover conductive layer CCL and may receive the common voltage ELVSS through the cover conductive layer CCL.

In some example embodiments , the opposite electrode 230 may overlap a portion of the cover conductive layer CCL and may not overlap the light blocking layer BM. For example, the opposite electrode 230 may be spaced apart from the light blocking layer BM in the plan view.

In some example embodiments , because the cover conductive layer CCL connects (or electrically connects) the second common voltage supply line 32 and the opposite electrode 230 to each other to transmit the common voltage EL VSS to the opposite electrode 230, the area of the opposite electrode 230 arranged in the peripheral area PA may be reduced compared to a comparative example in which the opposite electrode 230 does not include a cover conductive layer. When the area of the opposite electrode 230 arranged in the peripheral area PA is reduced, the degree of freedom in the design of a dam portion configured to control the reflow of the monomer such as the organic encapsulation layer 320 (see FIG. 5) may be increased.

However, the arrangement of the opposite electrode 230 is not limited to the illustration, and the opposite electrode 230 may entirely overlap the cover conductive layer CCL.

FIG. 12 is an enlarged plan view schematically illustrating a portion of a display panel according to some example embodiments and is an enlarged plan view of region 'C' of FIG. 7.

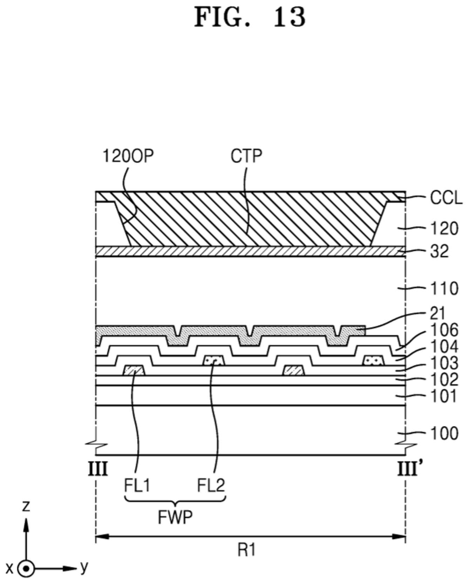

FIG. 13 is a cross-sectional view schematically illustrating the display panel of FIG. 12 along line III-III' according to some example embodiments .

Referring to FIGS. 12 and 13, the cover conductive layer CCL may include a contact portion CTP connected (or electrically connected) to the second common voltage supply line 32 in the region R1 overlapping the light blocking layer BM. Because the cover conductive layer CCL is connected (or electrically connected) to the second common voltage supply line 32, the cover conductive layer CCL may function as a common voltage transmission line configured to transmit the common voltage ELVSS and may improve the display quality of the display panel 10 (see FIG. 3) as described with reference to FIGS. 7 to 11.

In some example embodiments , the second via insulating layer 120 arranged between the second common voltage supply line 32 and the cover conductive layer CCL may include an opening 120OP surrounding each, or one or more, of the plurality of second through holes H2 in the plan view. The second via insulating layer 120 may include an opening 120OP surrounding each, or one or more, of the plurality of first through holes H1 in the plan view.

The opening 120OP of the second via insulating layer 120 may overlap the light blocking layer BM. Because the opening 120OP of the second via insulating layer 120 overlaps the light blocking layer BM (e.g., because the contact portion CTP of the cover conductive layer CCL overlaps the light blocking layer BM, the formation of areas with different external light reflectances due to the opening 120OP of the second via insulating layer 120 may be reduced or prevented. Accordingly, the display quality of the display panel 10 (see FIG. 3) may be improved.

The contact portion CTP of the cover conductive layer CCL may be arranged in the opening 120OP of the second via insulating layer 120 and may be connected (or electrically connected) to the second common voltage supply line 32. For example, the contact portion CTP of the cover conductive layer CCL may surround each, or one or more, of the plurality of second through holes H2 (or the first through holes H1) in the plan view.

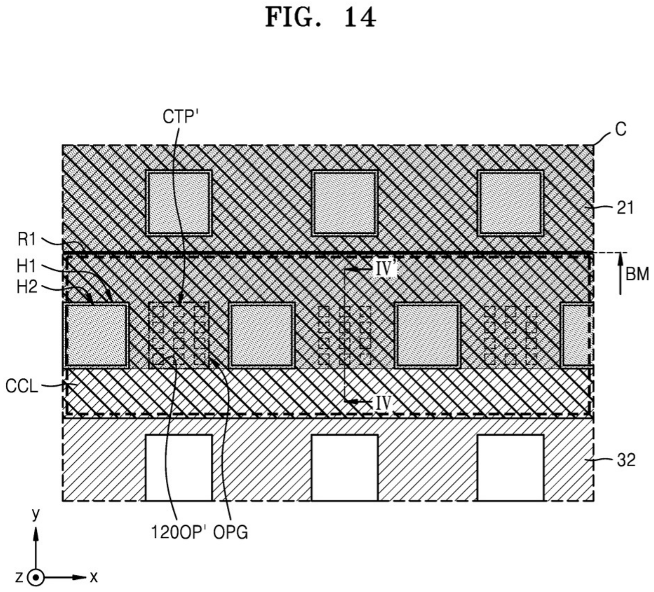

FIG. 14 is an enlarged plan view schematically illustrating a portion of a display panel according to some example embodiments and is an enlarged plan view of region 'C' of FIG. 7.

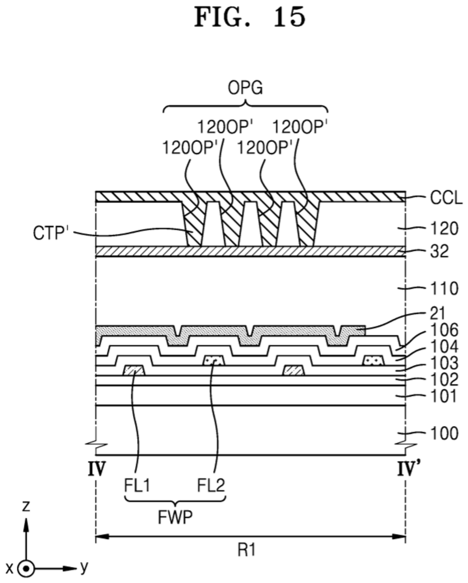

FIG. 15 is a cross-sectional view schematically illustrating the display panel of FIG. 14 along line IV-IV' according to some example embodiments .

Referring to FIGS. 14 and 15, the cover conductive layer CCL may include a contact portion CTP' connected (or electrically connected) to the second common voltage supply line 32 in the region R1 overlapping the light blocking layer BM.

In some example embodiments, the second via insulating layer 120 may include an opening group OPG including a plurality of openings 120OP' arranged between adjacent second through holes H2 among the plurality of second through holes H2 in the plan view. The opening group OPG may be provided as a plurality of opening groups OPG. The second via insulating layer 120 may include an opening group OPG including a plurality of openings 120OP' arranged between adjacent first through holes H1 among the plurality of first through holes H1 in the plan view.

The opening group OPG of the second via insulating layer 120 may overlap the light blocking layer BM. For example, the plurality of openings 120OP' of the second via insulating layer 120 may overlap the light blocking layer BM. Because the opening group OPG of the second via insulating layer 120 overlaps the light blocking layer BM (e.g., because the contact portion CTP' of the cover conductive layer CCL overlaps the light blocking layer BM), the formation of areas with different external light reflectances due to the opening group OPG of the second via insulating layer 120 may be reduced or prevented.

The contact portion CTP' of the cover conductive layer CCL may be arranged in the opening group OPG of the second via insulating layer 120. For example, the contact portion CTP' of the cover conductive layer CCL may be arranged in each, or one or more, opening 120OP' of the second via insulating layer 120 and may be connected (or electrically connected) to the second common voltage supply line 32. For example, the contact portion CTP' of the cover conductive layer CCL may be arranged between adjacent second through holes H2 among the plurality of second through holes H2 in the plan view.

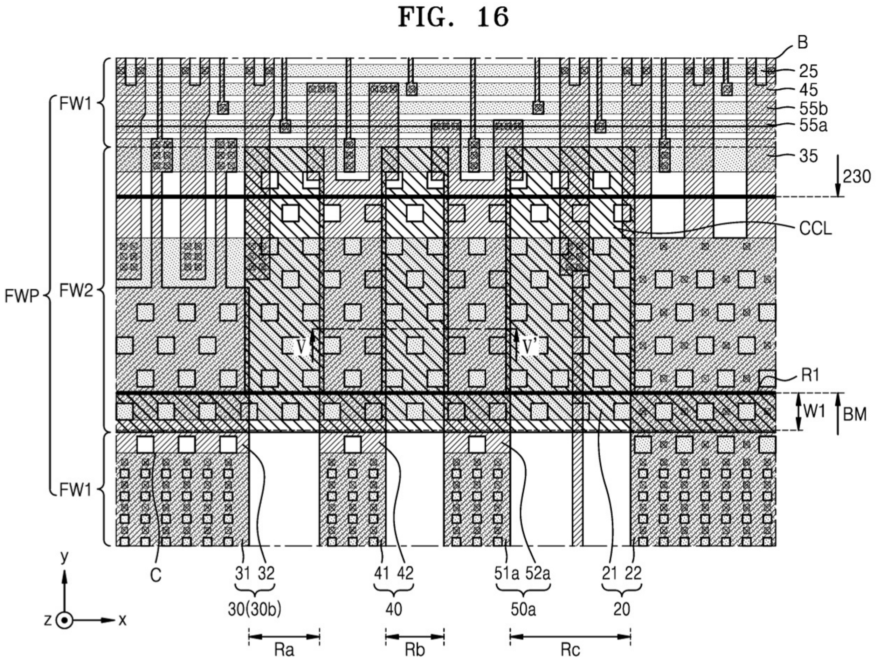

FIG. 16 is an enlarged plan view schematically illustrating a portion of a display panel according to some example embodiments and is an enlarged plan view of region 'B' of FIG. 6.

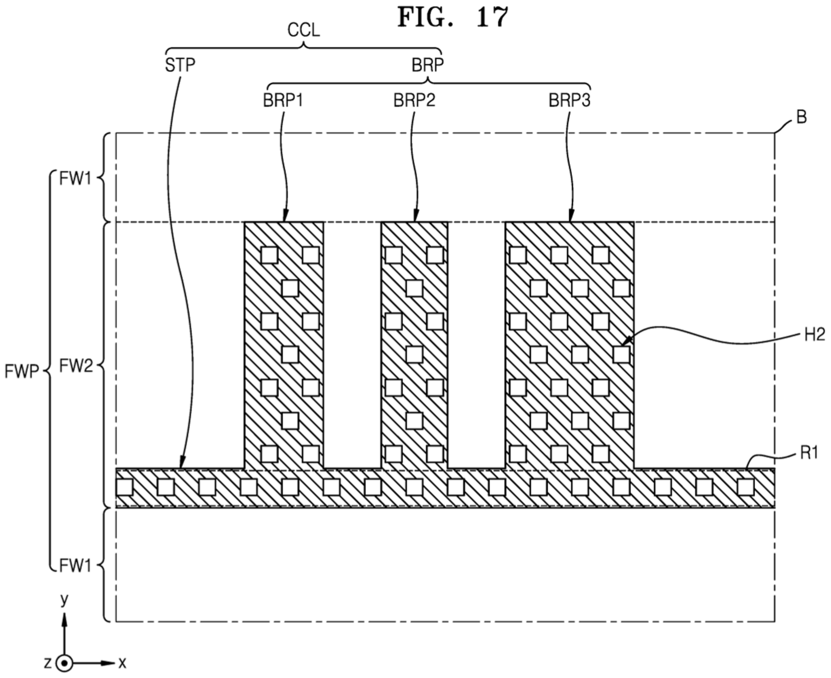

FIG. 17 is a plan view schematically illustrating a portion of the display panel illustrated in FIG. 7. FIG. 16 illustrates that the respective layers described with reference to FIGS. 8, 9, and 17 are sequentially stacked.

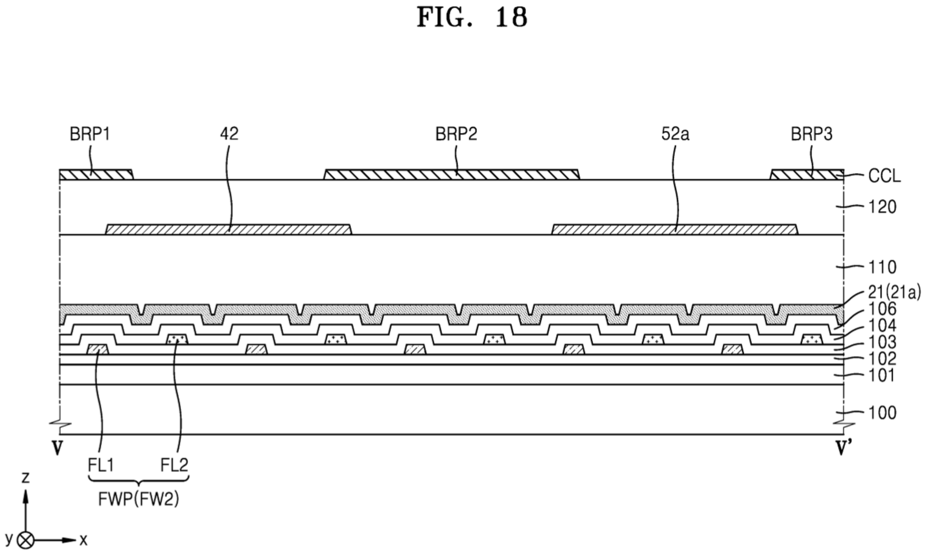

FIG. 18 is a cross-sectional view schematically illustrating the display panel of FIG. 16 along line V-V' according to some example embodiments.

In the example embodiments described with reference to FIGS. 16 to 18, redundant descriptions with those of the example embodiments described above with reference to FIGS. 6 to 11 will be omitted and differences therebetween will be mainly described.

Referring to FIGS. 16 to 18, in some example embodiments, the cover conductive layer CCL may include a stem portion STP overlapping the light blocking layer BM in an area overlapping the diagonal portion FW2 of the fan-out line portion FWP, and a branch portion BRP extending from the stem portion STP in the second direction (e.g., y direction) and covering at least a portion of the area between the second driving voltage supply line 22 and the second common voltage supply line 32.

The stem portion STP of the cover conductive layer CCL may be connected (or electrically connected) to the second common voltage supply line 32 in an area overlapping the light blocking layer BM. Because the stem portion STP of the cover conductive layer CCL includes a contact portion connected to the second common voltage supply line 32 in the region R1 overlapping the light blocking layer BM, the formation of areas with different external light reflectances due to the contact portion of the cover conductive layer CCL may be reduced or prevented. Accordingly, the display quality of the display panel 10 (see FIG. 3) may be improved.

The contact portion included in the stem portion STP of the cover conductive layer CCL may be described in the same manner as the description of the contact portion CTP described above with reference to FIGS. 12 and 13 and the description of the contact portion CTP' described above with reference to FIGS. 14 and 15. For example, the contact portion of the stem portion STP may surround each, or one or more, of the plurality of second through holes H2 (or the first through holes H1) in the plan view. For example, the contact portion of the stem portion STP may be arranged between adjacent second through holes H2 among the plurality of second through holes H2 in the plan view.

The branch portion BRP may include a plurality of sub-branches each, or one or more, extending from the stem portion STP in the second direction (e.g., y direction). The plurality of sub-branches may be spaced apart from each other in the first direction (e.g., x direction). For example, the branch portion BRP may include a first sub-branch portion BRP1, a second sub-branch portion BRP2, and/or a third sub-branch portion BRP3 each, or one or more, extending from the stem portion STP in the second direction (e.g., y direction). The first sub-branch portion BRP1, the second sub-branch portion BRP2, and the third sub-branch portion BRP3 may be spaced apart from each other in the first direction (e.g., x direction).

The first sub-branch portion BRP1 of the cover conductive layer CCL may cover or overlap the first region Ra between the second common voltage supply line 32 and the first upper initialization voltage supply line 42. The second sub-branch portion BRP2 of the cover conductive layer CCL may cover or overlap the second region Rb between the first upper initialization voltage supply line 42 and the second-1 upper initialization voltage supply line 52a. The third sub-branch portion BRP3 of the cover conductive layer CCL may cover or overlap the third region Rc between the second-1 upper initialization voltage supply line 52a and the second driving voltage supply line 22.

As an example, FIGS. 16 to 18 illustrate the first sub-branch portion BRP1, the second sub-branch portion BRP2, and the third sub-branch portion BRP3; however, the inventive concepts are not limited thereto. For example, the cover conductive layer CCL may further include a sub-branch portion covering or overlapping the area between the second common voltage supply line 32 and the second driving voltage supply line 22 adjacent to each other, as illustrated in FIG. 6. The cover conductive layer CCL may further include a sub-branch portion covering the area between the second driving voltage supply line 22 and the first upper initialization voltage supply line 42 adjacent to each other, a sub-branch portion covering the area between the second-1 upper initialization voltage supply line 52a and the second-2 upper initialization voltage supply line 52b adjacent to each other, and/or a sub-branch portion covering the area between the second-2 upper initialization voltage supply line 52b and the second common voltage supply line 32 adjacent to each other, as illustrated in FIG. 6.

Because the stem portion STP of the cover conductive layer CCL is connected (or electrically connected) to the second common voltage supply line 32, the stem portion STP of the cover conductive layer CCL may function as a common voltage transmission line configured to transmit the common voltage ELVSS.

In some example embodiments, in an area where the first portion 21a of the first driving voltage supply line 21 and the diagonal portion FW2 of the fan-out line portion FWP overlap each other, the cover conductive layer CCL may include sub-branch portions arranged on the second via insulating layer 120 to cover an area not overlapping the conductive layers over the first via insulating layer 110 of the first driving voltage supply line 21. Accordingly, the first portion 21a of the first driving voltage supply line 21 may not include an area not overlapping the conductive layers over the first via insulating layer 110. Thus, because external light is uniformly reflected by the cover conductive layer CCL, the phenomenon of reflective color bands may be effectively reduced, thus improving the display quality of the display panel 10 (see FIG. 3).

In some example embodiments, because the stem portion STP and the branch portion BRP are connected to each other, the entire cover conductive layer CCL may function as a common voltage transmission line configured to transmit the common voltage ELVSS and simultaneously may improve the display quality of the display panel 10 (see FIG. 3).

The opposite electrode 230 may extend from the display area DA (see FIG. 6) to the peripheral area PA (see FIG. 6) to overlap the branch portion BRP of the cover conductive layer CCL. The opposite electrode 230 may be electrically connected to the branch portion BRP of the cover conductive layer CCL and may receive the common voltage ELVSS through the cover conductive layer CCL.

The display apparatus 1 according to some example embodiments may be applied to various electronic apparatuses. An electronic apparatus according to some example embodiments may include the above display apparatus (e.g., the display apparatus 1 of FIG. 1) and may further include modules or devices having other additional functions in addition to the display apparatus.

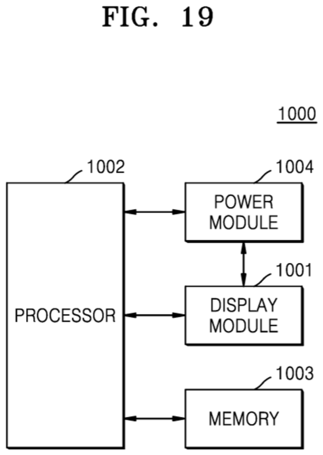

FIG. 19 is a block diagram of an electronic apparatus according to some example embodiments.

Referring to FIG. 19, an electronic apparatus 1000 according to some example embodiments may include a display module 1001, a processor 1002, a memory 1003, and/or a power module 1004.

The processor 1002 may include at least one of a central processing unit (CPU), an application processor (AP), a graphic processing unit (GPU), a communication processor (CP), an image signal processor (ISP), and a controller.

The memory 1003 may store data information necessary, or sufficient, for the operation of the processor 1002 or the display module 1001. When the processor 1002 executes an application stored in the memory 1003, an image data signal and/or an input control signal may be transmitted to the display module 1001 and the display module 1001 may process the received signal and output image information through a display screen.

The power module 1004 may include a power supply module such as a power adapter or a battery device, and a power conversion module that converts the power supplied by the power supply module to generate power necessary, or sufficient, for the operation of the electronic apparatus 1000.

At least one of the components of the electronic apparatus 1000 described above may be included in the display apparatus according to some example embodiments described above. Also, some of the individual modules functionally included in one module may be included in the display apparatus, and some others thereof may be provided separately from the display apparatus. For example, the display apparatus may include the display module 1001, and the processor 1002, the memory 1003, and the power module 1004 may be provided in the form of other devices in the electronic apparatus 1000 that is not the display apparatus.

In some example embodiments, the display module 1001 included in the display apparatus may operate based on an image data signal and may receive an input control signal from the processor 1002.

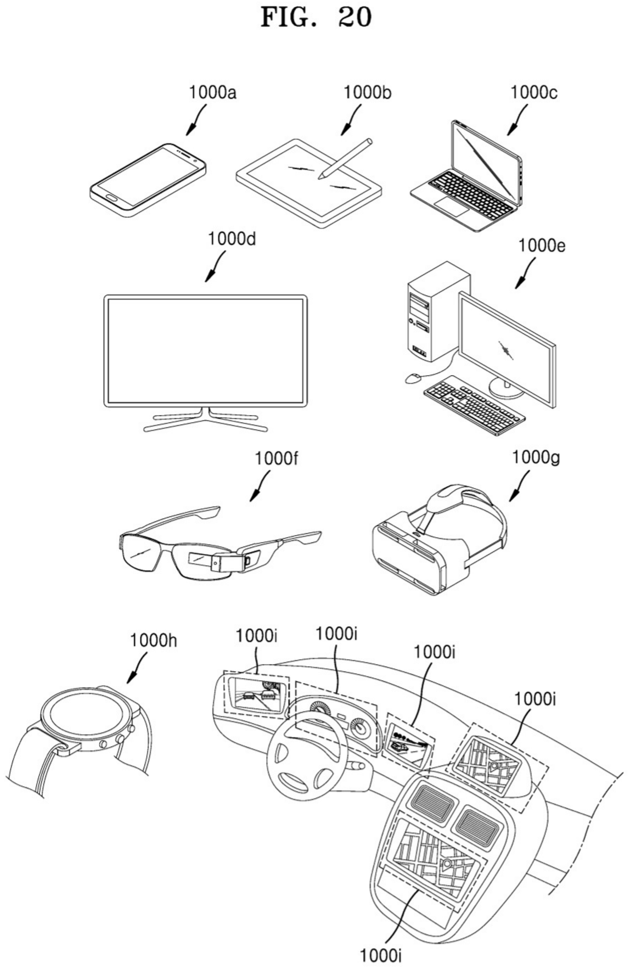

FIG. 20 schematically illustrates electronic apparatuses according to some example embodiments.

Referring to FIG. 20, various electronic apparatuses including the display apparatuses according to some example embodiments may include not only an electronic apparatus for displaying images, such as a smart phone 1000a, a tablet personal computer (PC) 1000b, a laptop computer 1000c, a television (TV) 1000d, and/or a desk monitor 1000e, but also a wearable electronic apparatus including a display module, such as smart glasses 1000f, a head-mounted display 1000g, and/or a smart watch 1000h, and/or a vehicle electronic apparatus 1000i including a display module, such as a center information display (CID) or a room mirror display arranged in the instrument panel, center fascia, or dashboard of a car.

According to some example embodiments, the display apparatus may include a cover conductive layer arranged in an area overlapping a diagonal portion of a fan-out line in the plan view, thus reducing a reflection band shape that may occur in an area where the diagonal portion of the fan-out line and a horizontal driving voltage supply line overlap each other, thereby improving the display quality of the display apparatus. However, the scope of the inventive concepts are not limited to these effects.

One or more of the elements disclosed above may include or be implemented in one or more processing circuitries such as hardware including logic circuits; a hardware/software combination such as a processor executing software; or a combination thereof. For example, the processing circuitries more specifically may include, but is not limited to, a central processing unit (CPU) , an arithmetic logic unit (ALU), a digital signal processor, a microcomputer, a field programmable gate array (FPGA), a Systemon-Chip (SoC), a programmable logic unit, a microprocessor, application-specific integrated circuit (ASIC), etc.

It should be understood that some example embodiments described herein should be considered in a descriptive sense only and not for purposes of limitation. Descriptions of features or aspects within each example embodiment should typically be considered as available for other similar features or some aspects in other example embodiments. While some example embodiments have been described with reference to the figures, it will be understood by those of ordinary skill in the art that various changes in form and details may be made therein without departing from the scope as defined by the following claims.

## Claims

1. A display apparatus (1) comprising:
a substrate (100) comprising a display area (DA) including a plurality of pixels and a peripheral area (PA) outside the display area and comprising a pad area (PADA);
a fan-out line portion (FWP) extending from the pad area to the display area in a plan view and comprising a straight portion (FW1) and a diagonal portion (FW2);
a first driving voltage supply line (21) disposed on the diagonal portion (FW2) of the fan-out line portion, overlapping the diagonal portion (FW2) of the fan-out line portion, and extending in a first direction in the plan view;
a second driving voltage supply line (22) disposed on the first driving voltage supply line (21), extending in a second direction intersecting the first direction in the plan view, and electrically connected to the first driving voltage supply line (21);
a common voltage supply line (32) disposed on the first driving voltage supply line (21) and spaced apart from the second driving voltage supply line (22) in the plan view;
a cover conductive layer (CCL) overlapping the diagonal portion (FW2) of the fan-out line portion, wherein the cover conductive layer (CCL) is disposed on the second driving voltage supply line (22) and the common voltage supply line (32) in the area overlapping the diagonal portion (FW2) of the fan-out line portion, covers at least a portion of an area between the second driving voltage supply line (22) and the common voltage supply line (32) in the plan view, and is electrically connected to the common voltage supply line (32); and
a light blocking layer (BM) disposed on the cover conductive layer in the peripheral area and overlapping a portion of the cover conductive layer,
wherein the cover conductive layer (CCL) comprises a contact portion (CTP) electrically connected to the common voltage supply line in an area overlapping the light blocking layer.

2. The display apparatus (1) of claim 1, wherein the common voltage supply line (32) comprises a plurality of first through holes passing through the common voltage supply line, and
the cover conductive layer (CCL) comprises a plurality of second through holes passing through the cover conductive layer (CCL) and respectively overlapping the plurality of first through holes.

3. The display apparatus (1) of claim 1 or 2, further comprising a via insulating layer (120) between the common voltage supply line and the cover conductive layer (CCL),
wherein the via insulating layer comprises an opening (120OP, 120OP') surrounding each of the plurality of second through holes in the plan view, and
the contact portion (CTP) of the cover conductive layer (CCL) is in the opening (120OP, 120OP') of the via insulating layer.

4. The display apparatus (1) of claim 3, wherein the opening (120OP, 120OP') of the via insulating layer overlaps the light blocking layer (BM).

5. The display apparatus (1) of claim 1 or 2, further comprising a via insulating layer between the common voltage supply line (32) and the cover conductive layer (CCL),
wherein the via insulating layer comprises an opening group (OPG) comprising a plurality of openings (120OP, 120OP') between adjacent second through holes among the plurality of second through holes in the plan view, and
the contact portion of the cover conductive layer (CCL) is in the opening group of the via insulating layer.

6. The display apparatus (1) of claim 5, wherein the opening group of the via insulating layer overlaps the light blocking layer.

7. The display apparatus (1) of any of the preceding claims, wherein the cover conductive layer (CCL) extends in the first direction, and/or
wherein the cover conductive layer (CCL) overlaps the diagonal portion (FW2) of the fan-out line portion.

8. The display apparatus (1) of any of the preceding claims, wherein the cover conductive layer (CCL) comprises a stem portion overlapping the light blocking layer and a branch portion extending from the stem portion in the second direction and covering at least a portion of an area between the second driving voltage supply line (22) and the common voltage supply line.

9. The display apparatus (1) of claim 8, further comprising a first initialization voltage supply line (40) on the first driving voltage supply line (21) and between the common voltage supply line (32) and the second driving voltage supply line (22) in the plan view,
wherein the branch portion of the cover conductive layer (CCL) comprises a first sub-branch portion covering an area between the common voltage supply line (32) and the first initialization voltage supply line (40), and/or,
further comprising a second initialization voltage supply line on the first driving voltage supply line (21) and between the first initialization voltage supply line (40) and the second driving voltage supply line (22) in the plan view,
wherein the branch portion of the cover conductive layer (CCL) comprises a second sub-branch portion spaced apart from the first sub-branch portion in the first direction and covering an area between the first initialization voltage supply line (40) and the second initialization voltage supply line.

10. The display apparatus (1) of any of the preceding claims, wherein the cover conductive layer (CCL) is spaced apart from the display area, and/or
wherein a width in the second direction of an area in which the contact portion of the cover conductive layer (CCL) and the light blocking layer overlap each other is 30 µm to 100 µm.

11. The display apparatus of any of the preceding claims, further comprising a driving voltage bus line (25) between the fan-out line portion and the display area in the plan view and extending in the second direction.

12. The display apparatus (1) of claim 11, wherein the cover conductive layer (CCL) does not overlap the driving voltage bus line (25).

13. The display apparatus (1) of any of the preceding claims, wherein each of the plurality of pixels comprises a light emitting diode,
the light emitting diode comprises a pixel electrode (210) on a pixel circuit layer, an emission layer (222) on the pixel electrode (210), and an opposite electrode (230) on the emission layer (222), and
the cover conductive layer (CCL) and the pixel electrode (210) are in a same layer.

14. The display apparatus (1) of claim 13, wherein the opposite electrode (230) extends from the display area to the peripheral area to overlap at least a portion of the cover conductive layer (CCL), and/or,
wherein the opposite electrode (230) overlaps a portion of the cover conductive layer (CCL) and does not overlap the light blocking layer.

15. An electronic apparatus (1000) comprising:
the display apparatus (1) of any of the preceding claims;
a memory (1003) configured to store an application; and
a processor (1002) configured to execute the application and transmit an image data signal or a control signal to the display apparatus (1).
